# EUROPEAN PATENT APPLICATION

(11) **EP 4 836 667 A1**
(43) Date of publication of application: **04.11.2026**
(21) Application number: 26173918.9
(22) Date of filing: 22.04.2026
(51) Int. Cl.: H10P 72/00, H10P 50/61

(54) **SUBSTRATE PROCESSING APPARATUS**

(30) Priority: 28.04.2025 JP 2025074556
(71) Applicant: SCREEN Holdings Co., Ltd., Kyoto-shi, Kyoto 602-8585 (JP)
(72) Inventor: WAKITA, Asuka, Kyoto, 602-8585 (JP); MORITA, Kosei, Kyoto, 602-8585 (JP); NAKANO, Hiroki, Kyoto, 602-8585 (JP)
(74) Representative: Kilian Kilian & Partner mbB

(57) **Abstract**

A top plate extends approximately across the upper surface of a substrate and faces it in the up-down direction. A barrier plate nozzle is fixedly attached to the top plate to eject a processing liquid from the lower surface of the top plate toward the upper surface of the substrate. A movable nozzle ejects a processing liquid from above to the upper surface of the substrate. A nozzle movement mechanism horizontally moves the movable nozzle above the substrate. With a liquid membrane formed as a result of the gap between the lower surface of the top plate and the upper surface of the substrate being filled with the processing liquid, a second electrode on the lower surface of the top plate is electrically connected to the processing liquid in direct contact with the liquid membrane. A third electrode is electrically connected to the processing liquid ejected from the movable nozzle.

## Description

### CROSS-REFERENCE TO RELATED APPLICATIONS

This application claims priority benefit of Japanese Patent Application No. JP2025-074556 filed in the Japan Patent Office on April 28, 2025, the entire disclosure of which is incorporated herein by reference.

### TECHNICAL FIELD

The present invention relates to a technique for performing etching on a substrate.

### BACKGROUND ART

A conventional process of manufacturing semiconductor substrates (hereinafter, simply referred to as "substrates") involves various types of processing that are performed on the substrates. For example, in the process of manufacturing a substrate, wet etching is performed on the substrate, in which an etchant is applied to the substrate to remove a membrane on the substrate. In the wet etching, it is known that the etch rate of the membrane becomes low within fine recessed portions such as trenches or holes provided in the substrate.

In view of this, Japanese Patent Application Laid-Open No. 2020-155614 (Document 1) proposes a technique for promptly allowing conductive components of a processing liquid to enter gaps in microstructures by supplying an etchant having conductivity to a substrate and applying a direct current of a certain magnitude between the substrate and the etchant adhering to the substrate. International Publication No. 2021/192502 (Document 2) proposes a technique for increasing an etch rate by applying an alternating voltage at a frequency of 0.1 kHz or 1 kHz to a pair of electrodes arranged to sandwich a substrate that is in contact with an etchant.

In the substrate processing apparatus according to Document 1, electrodes for etching are in contact with a central portion of a liquid membrane formed on the entire upper surface of the substrate. As result, the distance from the electrodes varies depending on the location on the substrate, which may cause variations in the etch rate. In the substrate processing apparatus according to Document 2, the processing liquid is stored in a frame body placed on the upper surface of the substrate, and electrodes are in contact with a central portion of the processing liquid. This may cause variations in etch rate depending on the location on the substrate as in Document 1.

### SUMMARY OF THE INVENTION

The present invention is intended for a substrate processing apparatus that performs etching on a substrate, and it is an object of the present invention to improve etching uniformity.

Aspect 1 of the present invention is a substrate processing apparatus that performs etching on a substrate. The substrate processing apparatus includes a substrate holder that holds a substrate in a horizontal position, the substrate having an upper surface on which a processing membrane is provided, a substrate rotation mechanism that rotates the substrate holder about a central axis extending in an up-down direction, a processing liquid supplier that supplies a processing liquid for etching to the upper surface of the substrate to bring the processing liquid into contact with the processing membrane, a barrier plate that extends across an entirety of the upper surface of the substrate and faces the upper surface of the substrate in the up-down direction, a barrier-plate movement mechanism that moves the barrier plate relative to the substrate in the up-down direction, a first electrode that is electrically connected to the substrate, a second electrode and a third electrode that are electrically connected to the processing liquid, and a power source capable of applying a voltage between the first electrode and the second electrode and between the first electrode and the third electrode. The processing liquid supplier includes a barrier plate nozzle that is fixedly attached to the barrier plate to eject the processing liquid from a lower surface of the barrier plate toward the upper surface of the substrate, a movable nozzle that ejects the processing liquid from above the substrate toward the upper surface of the substrate, and a nozzle movement mechanism that horizontally moves the movable nozzle above the substrate. When a liquid membrane is formed as a result of the processing liquid filling a gap between the lower surface of the barrier plate and the upper surface of the substrate, the second electrode provided on the lower surface of the barrier plate is electrically connected to the processing liquid in direct contact with the liquid membrane. The third electrode is electrically connected to the processing liquid ejected from the movable nozzle.

According to the present invention, it is possible to improve etching uniformity.

Aspect 2 of the present invention is the substrate processing apparatus according to Aspect 1 that further includes a controller that controls the substrate rotation mechanism, the processing liquid supplier, the barrier-plate movement mechanism, and the power source Under control of the controller, overall etching is performed on an entirety of the upper surface of the substrate by applying a voltage between the first electrode and the second electrode while the liquid membrane of the processing liquid supplied from the barrier plate nozzle is formed in the gap between the lower surface of the barrier plate and the upper surface of the substrate. Under control of the controller, local etching is performed on a partial region of the upper surface of the substrate by applying a voltage between the first electrode and the third electrode as well as ejecting the processing liquid from the movable nozzle while the barrier plate is retracted to a position above the substrate, and the movable nozzle is arranged at a desired position in a radial direction above the substrate that is being rotated.

Aspect 3 of the present invention is the substrate processing apparatus according to Aspect 2, in which, under control of the controller, the local etching is performed on the substrate after the overall etching is performed.

Aspect 4 of the present invention is the substrate processing apparatus according to Aspect 2 (or according to Aspect 2 or 3), in which the local etching is performed on a central portion of the substrate in the radial direction.

Aspect 5 of the present invention is the substrate processing apparatus according to Aspect 2 (or according to any one of Aspects 2 to 4), in which the local etching is performed on a peripheral edge portion of the substrate.

Aspect 6 of the present invention is the substrate processing apparatus according to Aspect 2 (or according to any one of Aspects 2 to 5), in which the third electrode is a flat plate-like member smaller than the upper surface of the substrate, the third electrode being mechanically connected to a lower end portion of the movable nozzle and facing the upper surface of the substrate in the up-down direction, and the local etching is performed while a liquid membrane is formed as the processing liquid fills a gap between a lower surface of the third electrode and the upper surface of the substrate.

Aspect 7 of the present invention is the substrate processing apparatus according to Aspect 2 (according to any one of Aspects 2 to 6) that further includes a heater that is provided in the substrate holder to heat the substrate from an underside. The heater is capable of changing an amount of heat applied per unit area of a lower surface of the substrate according to a distance from a center of the substrate.

Aspect 8 of the present invention is the substrate processing apparatus according to any one of Aspects 2 to 7, in which, in at least one of the overall etching or the local etching, a voltage applied between the first electrode and the second electrode or between the first electrode and the third electrode is repeatedly switched between a first voltage and a second voltage different from the first voltage in a predetermined switching cycle, to allow a potential on a side wall surface to be repeatedly switched between a first potential and a second potential lower than the first potential, the side wall surface forming a recessed portion in a pattern on the substrate. The first potential is higher than or equal to 0V, and the second potential is lower than or equal to 0V.

Aspect 9 of the present invention is the substrate processing apparatus according to Aspect 8, in which the switching cycle is more than or equal to 0.05 seconds.

These and other objects, features, aspects and advantages of the present invention will become more apparent from the following detailed description of the present invention when taken in conjunction with the accompanying drawings.

### BRIEF DESCRIPTION OF DRAWINGS

Fig. 1 is a plan view of a substrate processing system.
Fig. 2 is a side view of a substrate processing apparatus according to one embodiment.
Fig. 3 is a diagram showing a portion in the vicinity of one chuck pin in enlarged dimensions.
Fig. 4 is a sectional view showing part of a substrate in enlarged dimensions.
Fig. 5 is a flowchart showing a procedure for substrate processing.
Fig. 6 is a side view of the substrate processing apparatus.
Fig. 7 is a side view of the substrate processing apparatus.
Fig. 8A is a diagram showing a waveform of an applied voltage.
Fig. 8B is a diagram showing a waveform of an applied voltage.
Fig. 9A is a sectional view showing part of the substrate in enlarged dimensions.
Fig. 9B is a sectional view showing part of the substrate in enlarged dimensions.
Fig. 9C is a sectional view showing part of the substrate in enlarged dimensions.
Fig. 9D is a sectional view showing part of the substrate in enlarged dimensions.
Fig. 10A is a sectional view showing part of the substrate in enlarged dimensions.
Fig. 10B is a sectional view showing part of the substrate in enlarged dimensions.
Fig. 10C is a sectional view showing part of the substrate in enlarged dimensions.
Fig. 10D is a sectional view showing part of the substrate in enlarged dimensions.
Fig. 11 is a side view of the substrate processing apparatus.
Fig. 12 is a diagram showing laboratory equipment.
Fig. 13 is a sectional view showing part of the substrate in enlarged dimensions.
Fig. 14 is a side view of another substrate processing apparatus.
Fig. 15 is a side view of another substrate processing apparatus.
Fig. 16 is a side view of the other substrate processing apparatus.

### DESCRIPTION OF EMBODIMENTS

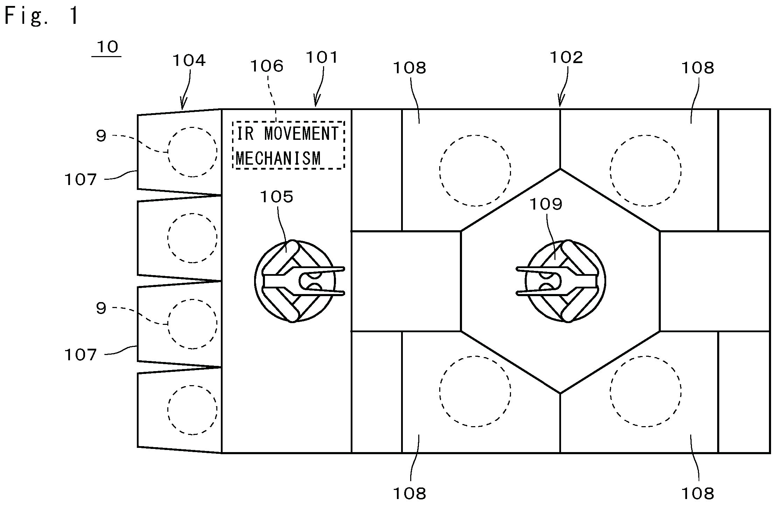

Fig. 1 is a diagrammatic plan view showing a layout of a substrate processing system 10. The substrate processing system 10 is a system that processes semiconductor substrates 9 (hereinafter, simply referred to as "substrates 9"). The substrate processing system 10 includes an indexer block 101 and a processing block 102 that is coupled to the indexer block 101.

The indexer block 101 includes a carrier holder 104, an indexer robot 105, and an IR movement mechanism 106. The carrier holder 104 holds a plurality of carriers 107 each capable of storing a plurality of substrates 9. The carriers 107 (e.g., FOUPs) are held by the carrier holder 104 while being aligned in a predetermined carrier alignment direction. The IR movement mechanism 106 moves the indexer robot 105 in the carrier alignment direction. The indexer robot 105 performs a transport-out operation of transporting the substrates 9 out of the carriers 107 and a transport-in operation of transporting the substrates 9 into the carriers 107 held by the carrier holder 104. The substrates 9 are transported in a horizontal position by the indexer robot 105.

The processing block 102 includes a plurality of (e.g., four or more) processing units 108 that process the substrates 9, and a center robot 109. The processing units 108 are arranged to surround the center robot 109 in plan view. The processing units 108 perform a variety of processing on the substrates 9. A substrate processing apparatus described later corresponds to one of the processing units 108. The center robot 109 performs a transport-in operation of transporting the substrates 9 into the processing units 108 and a transport-out operation of transporting the substrates 9 out of the processing units 108. The center robot 109 also transports the substrates 9 among the processing units 108. The substrates 9 are transported in a horizontal position by the center robot 109. The center robot 109 receives a substrate 9 from the indexer robot 105 or transfers a substrate 9 to the indexer robot 105.

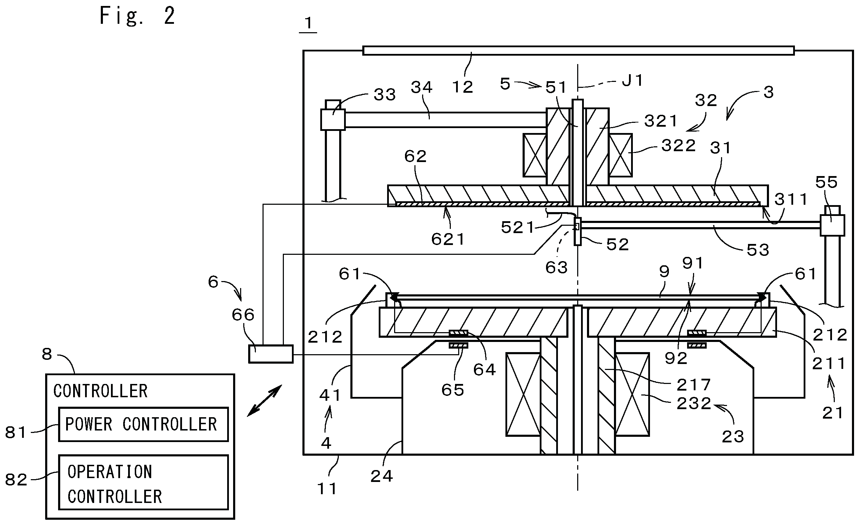

Fig. 2 is a side view showing a configuration of a substrate processing apparatus 1 according to one embodiment of the present invention. The substrate processing apparatus 1 is a single-wafer apparatus that processes the substrates 9 one by one. The substrate processing apparatus 1 is an apparatus that performs etching on a processing membrane provided on an upper-side main surface of the substrate 9 (hereinafter, also referred to as the "upper surface 91"). Fig. 2 shows part of the configuration of the substrate processing apparatus 1 in cross section.

The substrate processing apparatus 1 includes a substrate holder 21, a substrate rotation mechanism 23, an interrupter 3, a cup part 4, a processing liquid supplier 5, a voltage application unit 6, a housing 11, and a controller 8. The substrate holder 21, the substrate rotation mechanism 23, the interrupter 3, the cup part 4, and so on are housed in the internal space of the housing 11. The canopy portion of the housing 11 is provided with an airflow former 12 that supplies a gas to the internal space to form an airflow flowing downward (so-called a downflow). As the airflow former 12, for example, a fan filter unit (FFU) is used. The controller 8 is arranged outside the housing 11 and controls the substrate holder 21, the substrate rotation mechanism 23, the interrupter 3, the processing liquid supplier 5, the voltage application unit 6, and so on.

The controller 8 is, for example, a general computer system that includes a CPU, ROM, RAM, a fixed disk, a display, an input device, a reader, a communicator, and a bus. A processor configured by the CPU or the like executes processing such as arithmetic operations in accordance with instructions such as programs stored in memory configured by the ROM, the RAM, the fixed disk, and so on. The controller 8 includes a power controller 81 and an operation controller 82 as functions realized by the processor. The power controller 81 controls a power source 66 (described later) of the voltage application unit 6. The operation controller 82 controls the processing liquid supplier 5, the substrate rotation mechanism 23, and so on. Note that the controller 8 may, for example, be a programmable logic controller (PLC) or a circuit board. The controller 8 may include a plurality of arbitrary configurations among the computer system, the PLC, the circuit board, and so on.

The substrate holder 21 and the substrate rotation mechanism 23 each serve as part of a spin chuck that holds and rotates an approximately disc-like substrate 9. The substrate holder 21 supports the substrate 9 in a horizontal position from the underside. The substrate holder 21 illustrated in Fig. 2 is a mechanical chuck that mechanically holds the substrate 9.

The substrate holder 21 includes a base part 211, a plurality of (e.g., four or six) chuck pins 212, and a shaft 217. The base part 211 is an approximately disc-like member centered on a central axis J1 extending in the up-down direction. The substrate 9 is arranged above and spaced from the base part 211. In other words, the base part 211 of the substrate holder 21 faces a lower-side main surface of the substrate 9 (hereinafter, also referred to as the "lower surface 92") in the up-down direction at a position spaced below from the lower surface 92. The diameter of the base part 211 is slightly greater than the diameter of the substrate 9. The shaft 217 is an approximately columnar or cylindrical member centered on the central axis J1. The shaft 217 extends in the up-down direction and is connected to a central portion of the lower surface of the base part 211.

In the substrate holder 21, the chuck pins 212 are aligned in an upright position in a circumferential direction centered on the central axis J1 (hereinafter, also simply referred to as the "circumferential direction") on an outer peripheral portion of the upper surface of the base part 211. The chuck pins 212 are located at approximately the same position in a radial direction centered on the central axis J1 (hereinafter, also simply referred to as the "radial direction"). In other words, the chuck pins 212 are located on approximately the same circle centered on the central axis J1. For example, the chuck pins 212 are arranged at approximately equiangular intervals in the circumferential direction. The chuck pins 212 hold the substrate 9 in contact with the peripheral edge portion of the substrate 9.

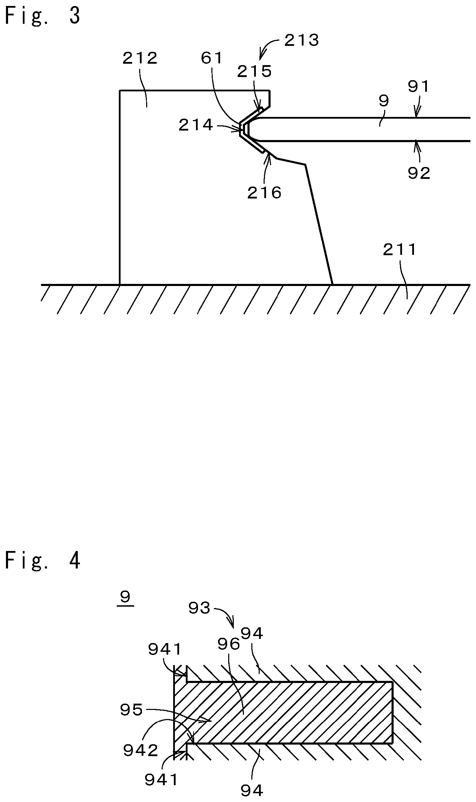

Fig. 3 shows a portion in the vicinity of one chuck pin 212 on the base part 211 in enlarged dimensions. The aforementioned multiple chuck pins 212 have approximately the same shape as the shape illustrated in Fig. 3. A radially inward side face in the upper portion of the chuck pin 212 (hereinafter, also referred to as the "upper inner side face 213) comes into direct contact with the peripheral edge portion of the substrate 9. A central portion 214 in the up-down direction of the upper inner side face 213 of the chuck pin 212 is recessed radially outward. In other words, the central portion 214 of the upper inner side face 213 of the chuck pin 212 is located radially outward of an upper portion 215 located above the central portion 214 and a lower portion 216 located below the central portion 214. When the substrate 9 is held by the substrate holder 21, the upper portion 215 of the upper inner side face 213 of the chuck pin 212 comes into direct contact with the peripheral edge portion of the upper surface 91 of the substrate 9, and the lower portion 216 of the upper inner side face 213 of the chuck pin 212 comes into direct contact with the peripheral edge portion of the lower surface 92 of the substrate 9.

As shown in Fig. 2, the substrate rotation mechanism 23 is arranged inside a cover part 24 that is arranged below the substrate holder 21. The cover part 24 is an approximately cylindrical covered member centered on the central axis J1. The upper surface of the cover part 24 and the lower surface of the base part 211 face each other in the up-down direction while being spaced from each other. There is a slight gap between the upper surface of the cover part 24 and the lower surface of the base part 211.

The substrate rotation mechanism 23 rotates the substrate 9 together with the substrate holder 21 about the central axis J1 extending approximately in parallel with the up-down direction. The substrate rotation mechanism 23 includes a motor 232. The motor 232 is an electric rotary motor that rotates the shaft 217 of the substrate holder 21. Note that the substrate rotation mechanism 23 may also be a motor having a different structure (e.g., a hollow motor).

The interrupter 3 includes a top plate 31, a top-plate rotation mechanism 32, and a top-plate movement mechanism 33. The top plate 31 is an approximately disc-like member centered on the central axis J1. The top plate 31 is spaced from and arranged above the upper surface 91 of the substrate 9, at a position located above the substrate 9 held by the substrate holder 21. The diameter of the top plate 31 is slightly greater than the diameter of the substrate 9. A lower surface 311 of the top plate 31 extends approximately across the entire upper surface 91 of the substrate 9 and faces the upper surface 91 in the up-down direction. The top plate 31 is an opposing member facing the upper surface 91 of the substrate 9 in the up-down direction and serves as a barrier plate that blocks the connection between the space above the substrate 9 and the surrounding space.

The top-plate rotation mechanism 32 is arranged above the top plate 31. The top-plate rotation mechanism 32 rotates the top plate 31 about the central axis J1. The top-plate rotation mechanism 32 includes a shaft 321 and a motor 322. The shaft 321 is an approximately cylindrical member centered on the central axis J1. The shaft 321 extends in the up-down direction and is connected to a central portion of the upper surface of the top plate 31. The motor 322 is an electric rotary motor that rotates the shaft 321. Note that the top-plate rotation mechanism 32 may also be any other motor having a different structure (e.g., a hollow motor).

The top-plate movement mechanism 33 serves as a barrier-plate movement mechanism that moves the top plate 31 in the up-down direction above the substrate 9. The top-plate movement mechanism 33 includes, for example, a ball screw and an electric rotary motor that are connected to the shaft 321 via an arm 34 extending approximately in a horizontal direction. The top-plate movement mechanism 33 may also be an electric linear motor, an air cylinder, or the like. Note that the top-plate movement mechanism 33 may move the substrate holder 21 in the up-down direction to move the top plate 31 relative to the substrate 9 in the up-down direction.

The processing liquid supplier 5 supplies a processing liquid to the substrate 9. The processing liquid supplier 5 includes a barrier plate nozzle 51 and a movable nozzle 52. The barrier plate nozzle 51 is an approximately cylindrical tube-like member that extends approximately horizontally in the up-down direction about the central axis J1. The barrier plate nozzle 51 is fixedly attached to the top plate 31 and arranged at a position that is located above the substrate 9 and spaced from the upper surface 91 of the substrate 9.

Specifically, the barrier plate nozzle 51 is arranged inside the shaft 321 of the top-plate rotation mechanism 32. When the shaft 321 is rotated by the motor 322 of the top-plate rotation mechanism 32, the barrier plate nozzle 51 remains stationary independently of the rotation of the shaft 321. Note that the barrier plate nozzle 51 may rotate together with the shaft 321. In the example shown in Fig. 2, the lower end of the barrier plate nozzle 51 is located at approximately the same position in the up-down direction as the lower surface 311 of the top plate 31. An ejection port of the barrier plate nozzle 51 at the lower end is located in an opening provided in the central portion of the lower surface 311 of the top plate 31, and faces a central portion (i.e., a central portion in the radial direction) of the upper surface 91 of the substrate 9 in the up-down direction.

The barrier plate nozzle 51 is capable of ejecting a processing liquid from the ejection port provided at the lower end toward the upper surface 91 of the substrate 9. That is, the barrier plate nozzle 51 is capable of ejecting a processing liquid from the lower surface 311 of the top plate 31 toward the upper surface 91 of the substrate 9. The processing liquid ejected from the barrier plate nozzle 51 comes into contact with the processing membrane provided on the upper surface 91 of the substrate 9. Note that the lower end of the barrier plate nozzle 51 may be located below the lower surface 311 of the top plate 31, or may be located above the lower surface 311 of the top plate 31.

The movable nozzle 52 is an approximately cylindrical tube-like member extending approximately in parallel with the up-down direction. The movable nozzle 52 is supported by an arm 53 extending approximately horizontally, and is arranged at a position that is located above the substrate 9 and spaced from the upper surface 91 of the substrate 9. The movable nozzle 52 is capable of ejecting a processing liquid from its ejection port provided at the lower end toward the upper surface 91 of the substrate 9. The processing liquid ejected from the movable nozzle 52 comes into contact with the processing membrane provided on the upper surface 91 of the substrate 9. The processing liquid ejected from the movable nozzle 52 is a liquid of the same type as the processing liquid ejected from the barrier plate nozzle 51.

The movable nozzle 52 is connected via piping 521 to a supply source (not shown) that delivers the processing liquid or the like. The piping 521 is, for example, a tube-like member having flexibility. The processing liquid or the like delivered from the aforementioned supply source is guided through the piping 521 to the movable nozzle 52 and is ejected from the movable nozzle 52 toward the upper surface 91 of the substrate 9 as described above.

The end of the arm 53 on the side opposite the movable nozzle 52 is connected to a nozzle movement mechanism 55. The nozzle movement mechanism 55 horizontally moves the movable nozzle 52 above the substrate 9 by rotating the arm 53 in the horizontal direction. For example, the nozzle movement mechanism 55 is capable of moving the movable nozzle 52 between a position above the substrate 9 and a retracted position that is located radially outward of the peripheral edge of the substrate 9. The nozzle movement mechanism 55 is also capable of arranging the movable nozzle 52 at a desired position in the radial direction above the substrate 9. The nozzle movement mechanism 55 further moves the movable nozzle 52 up and down by moving the arm 53 in the up-down direction. The nozzle movement mechanism 55 includes, for example, a ball screw and an electric rotary motor. The nozzle movement mechanism 55 may also be an electric rotary motor, an electric linear motor, an air cylinder, or the like.

The processing liquid supplied from each of the barrier plate nozzle 51 and the movable nozzle 52 toward the upper surface 91 of the substrate 9 is, for example, a liquid for etching (i.e., an etching liquid) used to etch the processing membrane provided on the upper surface 91 of the substrate 9. The processing liquid generally has conductivity. Examples of the etching liquid include etchants such as hydrogen peroxide (H₂O₂), hydrofluoric acid (HF), nitric acid (HNO₃), ammonia (NH₃), tetramethylammonium hydroxide (TMAH), and tetrabutylammonium hydroxide (TBAH).

Each of the barrier plate nozzle 51 and the movable nozzle 52 is also capable of ejecting a processing liquid used for rinse processing (i.e., a rinsing liquid) performed on the upper surface 91 of the substrate 9. As the rinsing liquid, deionized water (DIW) or the like may be used. Each of the barrier plate nozzle 51 and the movable nozzle 52 may also be configured to be capable of ejecting processing liquids other than an etching liquid and a rinsing liquid and/or inert gases or the like such as a nitrogen (N₂) gas.

The cup part 4 includes a cup 41 and a cup elevating mechanism, which is not shown. The cup 41 is an annular member centered on the central axis J1. The cup 41 is arranged along the entire circumferences of the substrate 9 and the substrate holder 21 and covers the sides and bottoms of the substrate 9 and the substrate holder 21. The cup 41 is a liquid-receiving container that receives a liquid such as the processing liquid that is scattered from the rotating substrate 9 to the surroundings. The inner surface of the cup 41 is formed of, for example, a water-repellent material. The cup 41 remains stationary in the circumferential direction, irrespective of whether the substrate 9 is rotating or remains stationary. The bottom of the cup 41 is provided with a drain port (not shown) through which the processing liquid or the like received by the cup 41 is discharged to the outside of the housing 11.

The aforementioned cup elevating mechanism moves the cup 41 relative to the substrate holder 21 in the up-down direction. The cup elevating mechanism is, for example, an electric linear motor, an air cylinder, or a combination of a ball screw and an electric rotary motor, any of which is connected to the cup 41. The cup elevating mechanism is capable of moving the cup 41 in the up-down direction between a processing position that is a position located around the substrate 9 shown in Fig. 2 and a retracted position that is located below the processing position.

The cup part 4 may include a plurality of cups 41 that are stacked one above another in the radial direction. In the case where the cup part 4 includes the multiple cups 41, the cups 41 are movable independently of one another in the up-down direction. Depending on the type of the processing liquid scattered from the substrate 9, the multiple cups 41 are switched and used to receive the processing liquid.

The voltage application unit 6 includes first electrodes 61, a second electrode 62, a third electrode 63, the power source 66, a first transmitter 64, and a second transmitter 65. Each first electrode 61 is provided on each chuck pin 212 of the substrate holder 21. Specifically, as shown in Fig. 3, the first electrodes 61 are approximately plate-like conductive members provided on the upper inner side faces 213 of the chuck pins 212. The radially inner surfaces of the first electrodes 61 are not covered with the chuck pins 212 and exposed from the upper inner side faces 213 of the chuck pins 212.

The first electrodes 51 are provided across the upper portions 215, the central portions 214, and the lower portions 216 of the upper inner side faces 213 of the chuck pins 212. The first electrodes 61 are electrically connected to the substrate 9 in direct contact with the peripheral edge portion of the substrate 9. In the example shown in Fig. 3, the first electrodes 61 come into direct contact with both of the upper surface 91 and the lower surface 92 of the substrate 9 on the peripheral edge portion of the substrate 9. The surface of a portion of each chuck pin 212 other than the portion where the first electrode 61 is provided is formed of, for example, an insulator. This surface may be formed of a conductor.

The second electrode 62 is provided in the lower surface 311 of the top plate 31. A lower surface 621 of the second electrode 62 is not covered with the top plate 31 and exposed from the lower surface 311 of the top plate 31. The second electrode 62 is, for example, an approximately annular plate-like conductive member centered on the central axis J1. In plan view (i.e., in a state viewed in parallel with the up-down direction), the outside diameter of the second electrode 62 is slightly smaller than the outside diameter of the top plate 31 and is approximately the same as the diameter of the substrate 9. Note that the outside diameter of the second electrode 62 may be either smaller or larger than the diameter of the substrate 9 in plan view. The lower surface 621 of the second electrode 62 faces approximately the entire upper surface 91 of the substrate 9 in the up-down direction. The lower surface 621 of the second electrode 62 is a flat surface that is approximately parallel to the upper surface 91 of the substrate 9.

As described later, when etching is performed on the upper surface 91 of the substrate 9, the top plate 31 comes into close proximity to the upper surface 91 of the substrate 9, and a liquid membrane of the processing liquid for etching is formed in the gap between the lower surface 311 of the top plate 31 and the upper surface 91 of the substrate 9. The second electrode 62 is electrically connected to the processing liquid in direct face-to-face contact with the liquid membrane.

The second electrode 62 and the multiple first electrodes 61 provided respectively on the multiple chuck pins 212 are formed of materials with high chemical resistance and high conductivity. The second electrode 62 and each first electrode 61 are formed of, for example, platinum (Pt) or glassy carbon (GC). Note that the shape, material, and so on of each first electrode 61 and the second electrode 62 may be changed in various ways.

The third electrode 63 is electrically connected to the processing liquid ejected from the movable nozzle 52. In the example shown in Fig. 2, the third electrode 63 is provided inside the movable nozzle 52 and electrically connected to the processing liquid flowing through a flow path inside the movable nozzle 52 in direct contact with the processing liquid. Before the processing liquid is ejected from the movable nozzle 52, the third electrode 63 is electrically connected to the processing liquid that is ejected from the movable nozzle 52. The third electrode 63 is formed of a material with high chemical resistance and high conductivity. The third electrode 63 is formed of, for example, platinum (Pt) or glassy carbon (GC). Note that the material, arrangement, and so on of the third electrode 63 may be changed in various ways.

The third electrode 63 does not necessarily have to be provided inside the movable nozzle 52. For example, in the case where the movable nozzle 52 is formed of a material with high conductivity such as glassy carbon, the third electrode 63 may be arranged so as to come into direct contact with the surface or the like of the movable nozzle 52. This allows the third electrode 63 to be electrically connected via the movable nozzle 52 to the processing liquid ejected from the movable nozzle 52 before the processing liquid is ejected from the movable nozzle 52.

Alternatively, in the case where the piping 521 is a conductive tube such as an anti-static (AS) tube, the third electrode 63 may be arranged so as to come into direct contact with the surface or the like of the piping 521. This allows the third electrode 63 to be electrically connected via the piping 521 to the processing liquid ejected from the movable nozzle 52 before the processing liquid is ejected from the movable nozzle 52. The materials or the like of the movable nozzle 52 and the piping 521 may be changed in various ways.

Note that, in the case where the movable nozzle 52 and the piping 521 are conductors, for example, the third electrode 63 may be electrically connected to at least one of the movable nozzle 52 and the piping 521. As another alternative, in the case where the movable nozzle 52 is a conductor, the movable nozzle 52 may be used as the third electrode 63. In the case where the piping 521 is a conductor, the piping 521 may be used as the third electrode 63.

The power source 66 is electrically connected to the first electrode 61, the second electrode 62, and the third electrode 63. The power source 66 is capable of applying a voltage between the first electrode 61 and the second electrode 62. The power source 66 is also capable of applying a voltage between the first electrode 61 and the third electrode 63. In the following description, the voltage applied between the first electrode 61 and the second electrode 62 from the power source 66 and the voltage applied between the first electrode 61 and the third electrode 63 from the power source 66 are also referred to as the "applied voltages". As the power source 66, for example, a power source capable of applying both a direct voltage and an alternating voltage is used. The power source 66 is controlled by the power controller 81 of the controller 8.

The power source 66 is mechanically and electrically connected to the third electrode 63 via an electric wire. The power source 66 is also mechanically and electrically connected via an electric wire to a slip ring (not shown) provided on the shaft 321 or the like of the top-plate rotation mechanism 32, and is electrically connected via this slip ring to the second electrode 62 provided in the top plate 31. In Fig. 2, in order to simplify the drawing, the power source 66 and the second electrode 62 are directly connected to each other via an electric wire.

In the example shown in Fig. 2, the power source 66 is electrically connected to each first electrode 61 via the second transmitter 65 and the first transmitter 64. The first transmitter 64 is provided in the base part 211 of the substrate holder 21. Specifically, for example, the first transmitter 64 is arranged inside the base part 211 in the vicinity of the lower surface of the base part 211. When the substrate holder 21 rotates, the first transmitter 64 rotates together with the substrate holder 21. The first transmitter 64 is an approximately annular plate-like power-receiving substrate centered on the central axis J1. The lower surface of the first transmitter 64 is provided with a power-receiving coil, and the upper surface of the first transmitter 64 has mounted thereon circuits parts for power reception. The first transmitter 64 is mechanically and electrically connected to each first electrode 61 via an electric wire arranged inside the base part 211.

The second transmitter 65 is arranged inside the cover part 24 and in the vicinity of the upper surface of the cover part 24. That is, the second transmitter 65 is spaced below from the base part 211 of the substrate holder 21. When the substrate holder 21 rotates, the second transmitter 65 remains stationary independently of the rotation of the substrate holder 21. The second transmitter 65 is, for example, an approximately annular plate-like power transmission substrate centered on the central axis J1. The second transmitter 65 faces the first transmitter 64 in the up-down direction while being spaced from the first transmitter 64. The shape of the second transmitter 65 in plan view is, for example, approximately the same as the shape of the first transmitter 64 in plan view. The upper surface of the second transmitter 65 is provided with a power-transmission coil, and the lower surface of the second transmitter 65 has mounted thereon circuit parts for power transmission. The second transmitter 65 is mechanically and electrically connected to the power source 66 via an electric wire.

When the power source 66 applies a voltage between the first electrode 61 and the second electrode 62 or between the first electrode 61 and the third electrode 63, the power-transmission coil of the second transmitter 65 and the power-receiving coil of the first transmitter 64 are magnetically coupled together so that electric power is transmitted from the second transmitter 65 to the first transmitter 64 without contact. That is, the first transmitter 64 and the second transmitter 65 serve as a wireless feeder device using a magnetic coupling system. Note that the shapes, structures, arrangement, and so on of the first transmitter 64 and the second transmitter 65 may be changed in various ways. For example, the first transmitter 64 and the second transmitter 65 may serve as a wireless feeder device using an electric-field coupling system.

Fig. 4 is a sectional view showing part of the substrate 9 in enlarged dimensions. In the example shown in Fig. 4, two microstructures 94 are shown among a large number of microstructures 94 that configure a fine pattern (hereinafter, also referred to as the "fine pattern 93") formed on the surface of the substrate 9. The microstructures 94 are fine structures provided on the upper surface of a substrate body formed of silicon (Si). For example, they may be structures formed of a single type of material, or may configure a laminated structure formed by laminating a plurality of types of materials.

The microstructures 94 are, for example, nanosheet channels having a gate all-around (GAA) structure, and a recessed portion 95 is a trench formed between the nanosheet channels. The processing membrane 96 is a metal gate electrode material in a replacement metal gate (RMG). Side wall surfaces 942 of the microstructures 94 that form the recessed portion 95 (i.e., the inner surface of the recessed portion 95) are formed of, for example, a High-k material with a higher relative dielectric constant than silicon dioxide (SiO₂). Examples of the High-k material that can be used include hafnium-, tungsten-, and cobalt-based materials.

The two microstructures 94 described above extend approximately linearly in a direction approximately perpendicular to the plane of the drawing in Fig. 4 (hereinafter, also referred to as the "longitudinal direction"). That is, Fig. 4 shows a longitudinal sectional view of the two microstructures 94 and also shows a longitudinal sectional view of the recessed portion 95 that is a fine gap formed between the two microstructures 94.

The width of the recessed portion 95 in a width direction perpendicular to the longitudinal direction (i.e., the up-down direction in Fig. 4) is, for example, less than or equal to 10 nm. The depth of the recessed portion 95 in the right-left direction in Fig. 4 is, for example, greater than or equal to 20 nm. The aspect ratio of the recessed portion 95, which is the ratio of the depth to the width (i.e., the value obtained by dividing the depth of the recessed portion 95 by the width thereof), is, for example, higher than or equal to 5.

Note that the recessed portion 95 may, for example, be a recessed portion other than a trench, such as an approximately circular hole in plan view. In the case where the recessed portion 95 is a hole, the aforementioned width of the recessed portion 95 corresponds to the diameter of the hole in plan view.

Fig. 4 shows the substrate 9 before etching is performed by the substrate processing apparatus 1. Before etching, the interior of the recessed portion 95 of the substrate 9 and end faces 941 of the two microstructures 94 are covered with the processing membrane 96. The processing membrane 96 is, for example, a conductive membrane formed of a conductor. For example, the processing membrane 96 is a metal membrane that contains one or more types of metals among titanium (Ti), tantalum (Ta), tungsten (W), copper (Cu), and aluminum (Al). For example, the processing membrane 96 contains at least one or more of titanium nitride (TiN), tantalum nitride (TaN), titanium aluminum (TiAl), and titanium aluminum carbide (TiAlC). Note that the processing membrane 96 may be formed of a material other than those described above (e.g., MnO). The thickness of the processing membrane 96 on the end faces 941 of the microstructures 94 (i.e., the thickness in the right-left direction in Fig. 4) is, for example, greater than or equal to 1 nm and less than or equal to 5 nm.

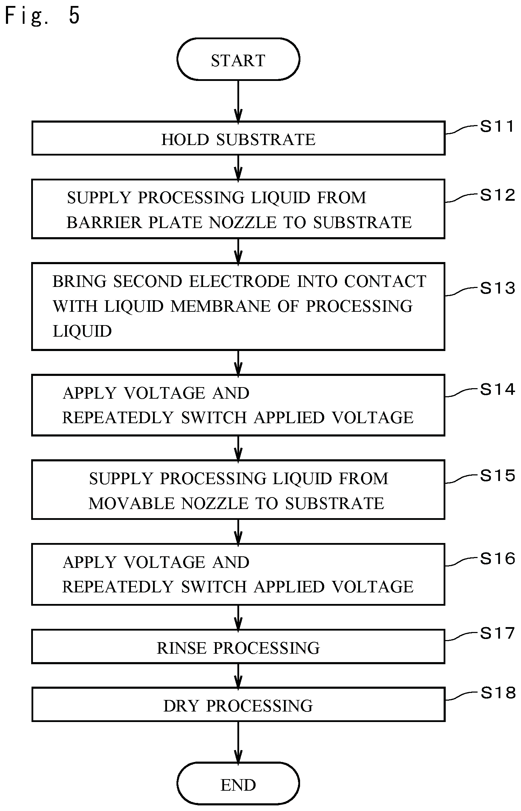

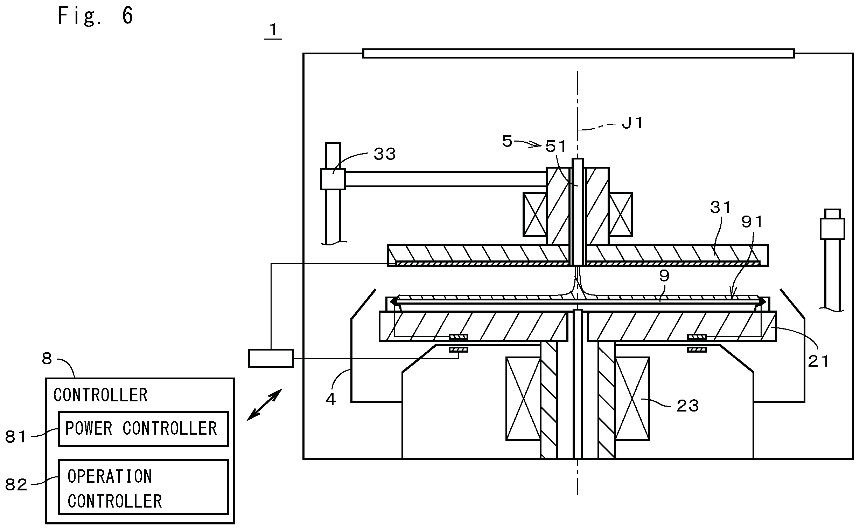

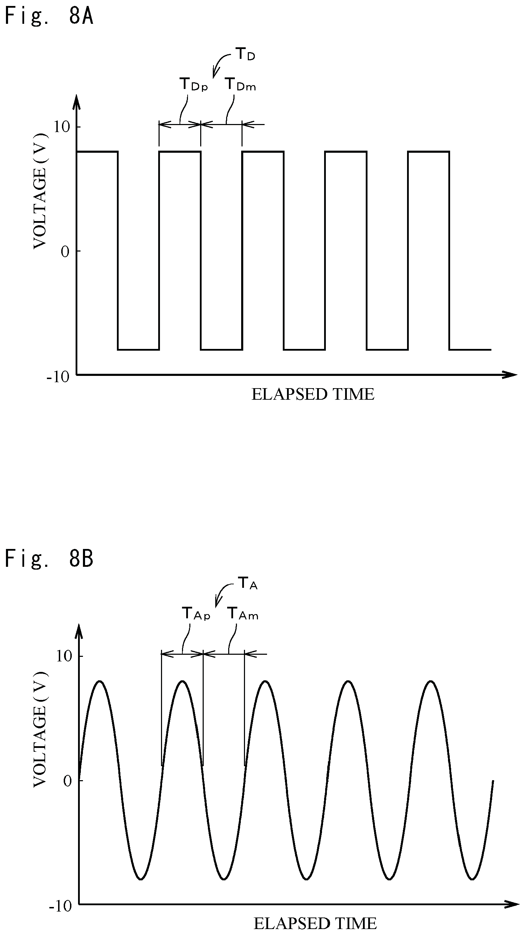

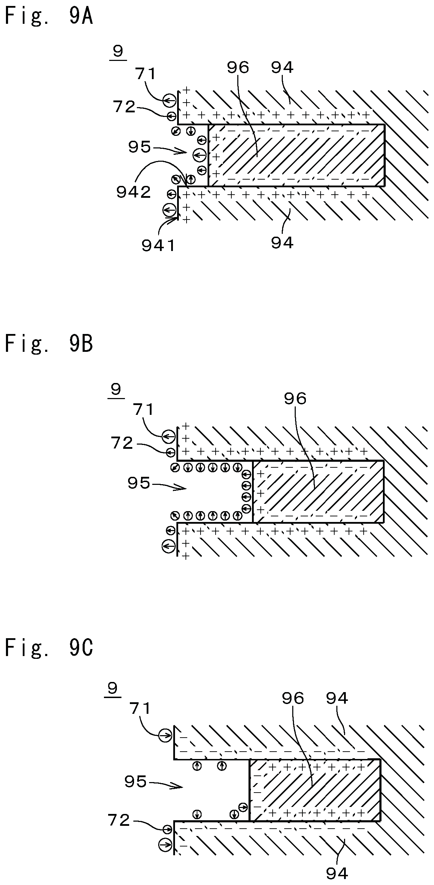

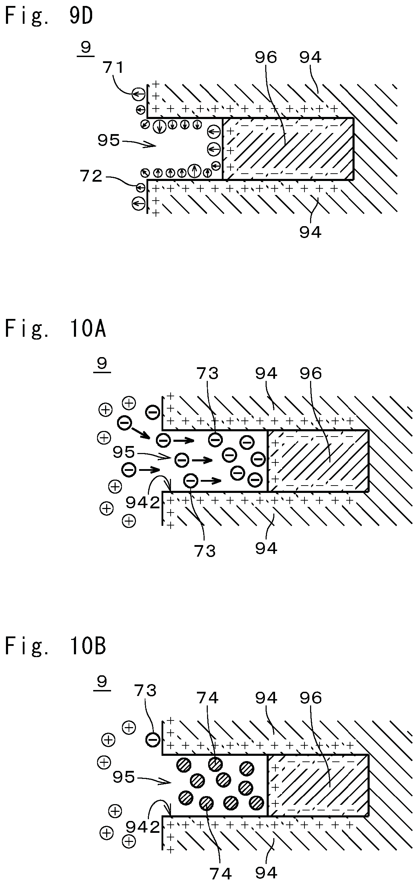

Next, a procedure for processing performed on the substrate 9 by the substrate processing apparatus 1 is described with reference to Figs. 5 to 11. Fig. 5 is a flowchart showing the procedure for processing performed on the substrate 9. Figs. 6, 7, and 11 are diagrams showing the substrate processing apparatus 1 in which the substrate 9 is being processed. Figs. 8A and 8B are diagrams each showing one example of the waveform of the applied voltage. Figs. 9A to 9D and Figs. 10A to 10D are sectional views showing part of the substrate 9 in enlarged dimensions.

The processing performed on the substrate 9 by the substrate processing apparatus 1 roughly involves overall etching and local etching that are performed on the substrate 9, the overall etching using the top plate 31 and the barrier plate nozzle 51, the local etching using the movable nozzle 52. When the overall etching and the local etching end, rinse processing and then dry processing are performed on the substrate 9.

In the case where processing is performed on the substrate 9, firstly, the substrate 9 is transported into the substrate processing apparatus 1 and held approximately in a horizontal position by the substrate holder 21 as shown in Fig. 2 (step S11). This brings the first electrodes 61 provided on the chuck pins 212 to come into direct contact with the substrate 9 and to be electrically connected to the substrate 9. When the substrate 9 is transported into the apparatus in step S11, the top plate 31 is located largely distanced above from the substrate holder 21. The movable nozzle 52 is located at the aforementioned retracted position.

When the substrate 9 is held by the substrate holder 21, the top-plate movement mechanism 33 moves down the top plate 31 to a predetermined position located above the substrate 9 (hereinafter, also referred to as the "ejection position") as shown in Fig. 6. Note that the movable nozzle 52 (see Fig. 2) is located at the aforementioned retracted position.

Then, the operation controller 82 of the controller 8 drives the substrate rotation mechanism 23 to start the rotation of the substrate 9. By the operation controller 82 controlling the processing liquid supplier 5, the processing liquid for etching is continuously supplied from the barrier plate nozzle 51 toward the central portion of the upper surface 91 of the substrate 9. The processing liquid spreads across the entire upper surface 91 of the substrate 9 due to centrifugal force caused by the rotation of the substrate 9 and comes into contact with the processing membrane 96 (see Fig. 4) on the substrate 9 (step S12). In step S12, the substrate 9 is rotated at a relatively low speed, so that approximately the entre upper surface 91 of the substrate 9 is covered with the processing liquid for etching. That is, in step S12, so-called puddle forming takes place approximately across the entire upper surface 91 of the substrate 9. Part of the processing liquid supplied to the substrate 9 is scattered radially outward from the peripheral edge of the substrate 9 by centrifugal force caused by the rotation of the substrate 9, and is received by the cup part 4. The rotational frequency of the substrate 9 in step S12 is, for example, lower than or equal to 15 rpm.

In the present embodiment, the processing membrane 96 is a conductive membrane formed of titanium nitride (TiN), and the side wall surfaces 942 of the microstructures 94 (see Fig. 4) are formed of hafnium oxide (HfO₂). The above-described processing liquid is a liquid with conductivity obtained by adding an electrolytic solution to hydrogen peroxide water serving as an etching liquid. The processing liquid has resistivity of, for example, lower than or equal to 0.1 Ω·m and preferably lower than or equal to 0.05 Ω·m. As the above electrolytic solution, for example, an aqueous solution such as hydrochloric acid (HCl), sulfuric acid (H₂SO₄), or ammonia (NH₃) may be used. Note that the resistivity of the processing liquid may be higher than 0.1 Ω·m. The processing liquid may also be a hydrogen peroxide solution alone with nothing such as hydrochloric acid added thereto. The processing liquid may also be SC2 that is a mixed solution of hydrogen peroxide water and a hydrochloric acid solution.

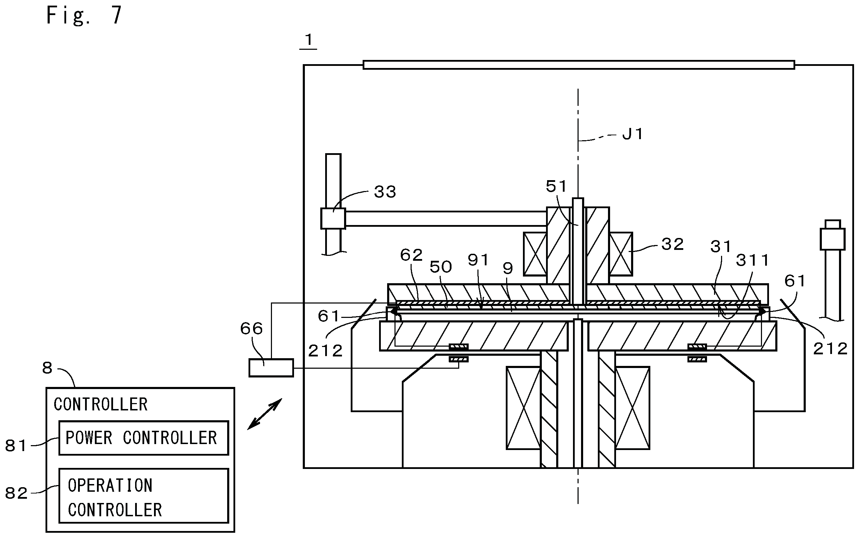

When the entire upper surface 91 of the substrate 9 is covered with the processing liquid for etching, the top-plate movement mechanism 33 moves down the top plate 31 to a position that is located in closer proximity to the substrate 9 in the up-down direction than the ejection position (see Fig. 6) as shown in Fig. 7. In the following description, the position of the top plate 31 shown in Fig. 7 is also referred to as the "etching position".

With the top plate 31 located at the etching position, the lower surface 311 of the top plate 31 is slightly spaced above from the upper surface 91 of the substrate 9. The distance in the up-down direction between the lower surface 311 of the top plate 31 and the upper surface 91 of the substrate 9 is, for example, about 4 mm. Approximately the entire gap between the lower surface 311 of the top plate 31 and the upper surface 91 of the substrate 9 is filled with the aforementioned processing liquid, so that a liquid membrane 50 of the processing liquid is formed. The second electrode 62 provided in the lower surface 311 of the top plate 31 comes in direct contact with the upper surface of the liquid membrane 50 and is accordingly electrically connected to the processing liquid for etching, which forms the liquid membrane 50 (step S13).

The liquid membrane 50 is formed approximately across the entire upper surface 91 of the substrate 9 as described above. For example, the liquid membrane 50 is in direct contact with the first electrodes 61 provided on the chuck pins 212 on the peripheral edge portion of the substrate 9. In other words, each of the first electrode 61 comes into direct contact with a peripheral edge portion of the liquid membrane 50. Note that each first electrode 61 does not necessarily have to come into direct contact with the liquid membrane 50.

With the top plate 31 located at the etching position, the ejection of the processing liquid from the barrier plate nozzle 51 may be continued or stopped. The rotation of the substrate 9 may also be continued or stopped. When located at the etching position, the top plate 31 may be rotated by the top-plate rotation mechanism 32, or may remain stationary without rotation. In the case where the top plate 31 is rotated, the rotational frequency and rotational direction of the top plate 31 are, for example, the same as the rotational frequency and rotational direction of the substrate 9. In the case where the top plate 31 is not rotated, the top-plate rotation mechanism 32 may be omitted.

Then, the power controller 81 of the controller 8 controls the power source 66 so that a voltage is applied between the first electrode 61 and the second electrode 62. Accordingly, the voltage is applied via the processing liquid on the substrate 9 between the second electrode 62 and the substrate 9 that is electrically connected to the first electrode 61. In other words, the substrate 9 and the second electrode 62 serve as a pair of electrodes with the processing liquid sandwiched therebetween, and the voltage is applied between the pair of electrodes.

The voltage applied between the first electrode 61 and the second electrode 62 is repeatedly switched between a first voltage and a second voltage different from the first voltage in a predetermined switching cycle under the control of the power controller 81. Accordingly, the potential on the side wall surfaces 942 (see Fig. 4) of the microstructure 94 is repeatedly switched between a first potential and a second potential in the above switching cycle (step S14).

The power source 66 applies a voltage to the first electrode 61 with reference to the potential of the second electrode 62. Thus, the first potential and the second potential are potentials determined with reference to the second electrode 62. The first potential is higher than or equal to zero volts (V). The second potential is lower than or equal to 0V and lower than the first potential. Thus, in the case where the first potential is 0V, the second potential is less than 0V. The first potential is, for example, less than or equal to +8V. The second potential is, for example, higher than or equal to -8V. The upper limit for the first potential and the lower limit for the second potential may be changed in various ways.

The aforementioned switching cycle is preferably more than or equal to 0.05 seconds. The switching cycle is preferably less than or equal to 20 seconds. In the case where the applied voltage is a direct voltage, the switching cycle is preferably more than or equal to 0.5 seconds, more preferably more than equal to one seconds, and yet more preferably more than or equal to two seconds. In the case where the applied voltage is a direct voltage, the switching cycle is preferably less than or equal to 18 seconds, more preferably less than or equal to 12 seconds, and yet more preferably less than or equal to 6 seconds.

In the case where the applied voltage is an alternating voltage, the aforementioned switching cycle of more than or equal to 0.05 seconds corresponds to a frequency of lower than or equal to 20 Hz, and the switching cycle of less than or equal to 20 seconds corresponds to a frequency of higher than or equal to 0.05 Hz. In the case where the applied voltage is an alternating voltage, the switching cycle is preferably more than or equal to 0.1 seconds (i.e., a frequency of lower than or equal to 10 Hz) and more preferably more than or equal to 0.2 seconds (i.e., a frequency of lower than or equal to 5 Hz). In the case where the applied voltage is an alternating voltage, the switching cycle is preferably less than or equal to two seconds (i.e., a frequency of higher than or equal to 0.5 Hz) and more preferably less than or equal to one seconds (i.e., a frequency of higher than or equal to 1 Hz).

The switching of the applied voltage in step S14 (i.e., the switching of the potential on the side wall surfaces 942) is continuously performed for a predetermined period of time while the liquid membrane 50 of the processing liquid is in contact with the processing membrane 96 (see Fig. 4) on the substrate 9. This allows etching (so-called electrolyte etching) to be performed on approximately the entire upper surface 91 of the substrate 9, resulting in removal of the processing membrane 96 from above the upper surface 91 of the substrate 9. In the following description, the etching performed using the second electrode 62 on approximately the entire upper surface 91 of the substrate 9 is also rereferred to as the "overall etching".

Figs. 8A and 8B are diagrams each showing one example of the waveform of the voltage applied from the power source 66 in step S14. Fig. 8A shows one example of the waveform when the applied voltage is a direct voltage, and Fig. 8B shows one example of the waveform when the applied voltage is an alternating voltage. In Figs. 8A and 8B, the horizontal axis indicates the elapsed time, and the vertical axis indicates the voltage applied between the first electrode 61 and the second electrode 62. In the specification of the present invention, it is assumed that the applied voltage is positive when the potential of the first electrode 61 is higher than the potential of the second electrode 62, and the applied voltage is negative when the potential of the first electrode 61 is lower than the potential of the second electrode 62. In the following description, the case where the applied voltage is positive is also expressed as "applying a positive voltage to the first electrode 61", and the case where the applied voltage is negative is also expressed as "applying a negative voltage to the first electrode 61".

In the example shown in Fig. 8A, the waveform of the applied voltage is a rectangular wave. A maximum value (i.e., the first voltage) of the applied voltage is +8V, and a minimum value (i.e., the second voltage) of the applied voltage is -8V. As described above, the applied voltage is repeatedly switched between the first voltage and the second voltage in a predetermined switching cycle T_{D}. In the following description, in each switching cycle T_{D} of the applied voltage, a duration in time when the applied voltage is positive is also referred to as a "first application time T_{Dp}", and a duration in time when the applied voltage is negative is also referred to as a "second application time T_{Dm}". In the example shown in Fig. 8A, the first application time T_{Dp} and the second application time T_{Dm} are the same and equal to T_{D}/2. Note that the first voltage and the second voltage may be changed as appropriate, and their absolute values do not necessarily have to be the same. The first application time T_{Dp} and the second application time T_{Dm} also do not necessarily have to be the same, and may be different.

Fig. 8B shows one example of the waveform when the applied voltage is an alternating voltage. In the example shown in Fig. 8B, the waveform of the alternating voltage is a sinusoidal wave. In Fig. 8B, the vertical axis indicates the instantaneous value of the applied voltage. A maximum value (i.e., the first voltage) of the applied voltage is +8V, and a minimum value (i.e., the second voltage) of the applied voltage is -8V. As described above, the applied voltage is repeatedly switched between the first voltage and the second voltage in a predetermined switching cycle T_{A}. In the following description, in each switching cycle T_{A} of the applied voltage, a duration in time when the applied voltage is positive is also referred to as a "first application time T_{Ap}", and a duration in time when the applied voltage is negative is also referred to as a "second application time T_{Am}". In the example shown in Fig. 8B, the first application time T_{Ap} and the second application time T_{Am} are the same and equal to T_{A}/2. Note that the first voltage and the second voltage may be changed as appropriate, and their absolute values do not necessarily have to be the same. The first application time T_{Ap} and the second application time T_{Am} also do not necessarily have to be the same, and may be different. In the case where the applied voltage is an alternating voltage, the waveform of the applied voltage is not limited to a sinusoidal wave, and for example, may be a triangular wave or a sawtooth wave.

In step S14 described above, the power controller 81 controls the power source 66 so that the applied voltage is repeatedly switched between the first voltage and the second voltage. This accelerates the etching of the processing membrane 96 and increases the etch rate. In particular, the etching of the processing membrane 96 within the recessed portion 95 is accelerated, which results in an increase in the etch rate.

Strictly speaking, the principle behind the increase in the etch rate of the processing membrane 96 within the recessed portion 95 as a result of repeatedly switching the applied voltage has not yet been determined. The following description provides a plurality of conceivable principles as candidates for this principle.

First, a first principle is described with reference to Figs. 9A to 9D, which are sectional views approximately the same as the sectional view in Fig. 4. Figs. 9A to 9D show situations in which the etching of the processing membrane 96 shown in Fig. 4 has progressed to some extent so that the processing membrane 96 on the end faces 941 of the microstructures 94 has been removed, and the processing membrane 96 inside the recessed portion 95 has also been removed slightly. To simplify the drawings, Figs. 9A to 9D schematically illustrate the processing membrane 96 such that its surface (i.e., the end face on the side opposite the bottom of the recessed portion 95; the face on the left side in the drawings) becomes perpendicular to the right-left direction. The same also applies to Figs.10A to 10D, which will be described later. In the examples shown in Figs. 9A to 9D, the processing liquid used in etching is described as containing hydrogen peroxide as an etchant.

Fig. 9A shows a state in which a positive voltage is applied to the first electrode 61 (see Fig. 2). The application of the positive voltage to the first electrode 61 causes the surface of the processing membrane 96 within the recessed portion 95 to become positively charged. The side wall surfaces 942 of the two microstructures 94 located on the opposite sides of the recessed portion 95 (i.e., the inner surface of the recessed portion 95) and the end faces 941 thereof also become positively charged. Thus, hydrogen peroxide molecules 71 and water molecules 72, which are polar molecules (also referred to as dipoles), adsorb onto the surface of the processing membrane 96 and the surfaces of the microstructures 94 (i.e., the side wall surfaces 942 and the end faces 941 described above). Specifically, portions of the hydrogen peroxide molecules 71 where the negative charge is concentration and portions of the water molecules 72 where the negative charge is concentrated adsorb onto the surfaces of the processing membrane 96 and the microstructures 94.

In Fig. 9A, the hydrogen peroxide molecules 71 are schematically indicated by circles, and a deviation in the charge of the hydrogen peroxide molecules 71 is indicated by an arrow within each circle. Specifically, portions of the hydrogen peroxide molecules 71 where the positive charge is concentrated are indicated by the tips of the arrows (i.e., arrowheads), and portions of the hydrogen peroxide molecules 71 where the negative charge is concentrated are indicated by the ends of the arrows on the side opposite the tips thereof. Approximately the same also applies to the water molecules 72. Note that the circles schematically indicating the water molecules 72 are illustrated smaller than the circles schematically indicating the hydrogen peroxide molecules 71. The same also applies to Figs. 9B and 9D.

When a positive voltage is applied to the first electrode 61, the processing membrane 96 is etched by the hydrogen peroxide molecules 71 adsorbing on the surface of the processing membrane 96. The hydrogen peroxide molecules 71 used in the etching of the processing membrane 96 turn into hydroxide ions (OH⁻) or the like and disappear from the surface of the processing membrane 96. Thus, as the etching of the processing membrane 96 progresses, the hydrogen peroxide molecules 71 decrease in number or disappear from the surface of the processing membrane 96 and from portions of the surfaces of the microstructures 94 that are located in the vicinity of the processing membrane 96 (i.e., the inner surface of the recessed portion 95), and as shown in Fig. 9B, the surface of the processing membrane 96 and the inner surface of the recessed portion 95 are covered with the water molecules 72. As a result, the adsorption of the hydrogen peroxide molecules 71 onto the surface of the processing membrane 96 is inhibited, which lowers the etch rate of the processing membrane 96 or stops the etching of the processing membrane 96.

In view of this, the substrate processing apparatus 1 causes the surfaces of the processing membrane 96 and the microstructures 94 to become negatively charged as shown in Fig. 9C by switching the polarity of the voltage applied to the first electrode 61 with predetermined timing so that a negative voltage is applied to the first electrode 61. This causes the water molecules 72 adsorbing on the surfaces of the processing membrane 96 and the microstructures 94 (e.g., the inner surface of the recessed portion 95) to become electrolyzed into hydrogen molecules and hydroxide ions and to be removed from the surfaces of the processing membrane 96 and the microstructures 94. As a result, the hydrogen peroxide molecules 71 become capable of adsorbing onto the surface of the processing membrane 96.

The substrate processing apparatus 1 also causes the surfaces of the processing membrane 96 and the microstructures 94 (e.g., the inner surface of the recessed portion 95) to become positively charged as shown in Fig. 9D by switching the polarity of the voltage applied to the first electrode 61 with predetermined timing so that a positive voltage is applied to the first electrode 61. This causes the hydrogen peroxide molecules 71 to adsorb onto the surface of the processing membrane 96 and etch the processing membrane 96. As a result, the etching of the processing membrane 96 within the recessed portion 95 is accelerated, resulting in an increase in the etch rate.

Next, a second principle is described with reference to Figs. 10A to 10D. Fig. 10A shows a state in which a positive voltage is applied to the first electrode 61 (see Fig. 2). The application of the positive voltage to the first electrode 61 causes the side wall surfaces 942 of the two microstructures 94 (i.e., the inner surface of the recessed portion 95) located on the opposite sides of the recessed portion 95 to become positively charged. In other words, the potential on the side wall surfaces 942 of the microstructures 94 becomes higher than the potential in the processing liquid. This allows minus ions 73 existing as etchants around the recessed portion 95 to easily enter the recessed portion 95. As a result, the area of contact between the surface of the processing membrane 96 and the minus ions 73 serving as etchants increases, which accelerates the etching of the processing membrane 96.

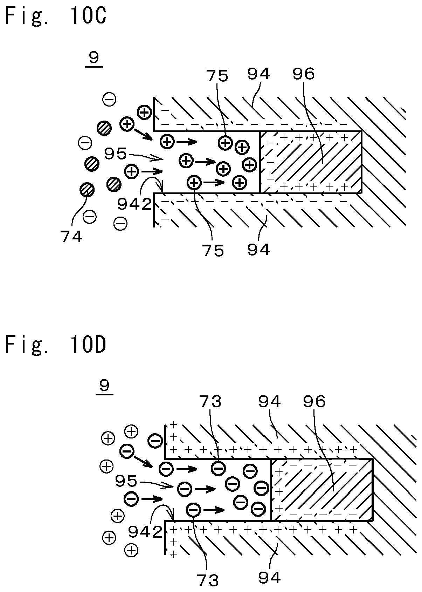

As the etching of the processing membrane 96 progresses, products 74 that are generated by etching and become negatively charged increase in number and become trapped in the recessed portion 95 as shown in Fig. 10B. This makes it hard for the minus ions 73 serving as etchants to enter the recessed portion 95. As a result, the area of contact between the minus ions 73 and the processing membrane 96 decreases, which lowers the etch rate of the processing membrane 96 or stops the etching of the processing membrane 96. In Fig. 10B, the products 74 are hatched in order to facilitate understanding of the drawing (the same also applies to Fig. 10C).

In view of this, the polarity of the voltage applied to the first electrode 61 is switched with predetermined timing so that a negative voltage is applied to the first electrode 61. This causes the side wall surfaces 942 of the two microstructures 94 located on the opposite sides of the recessed portion 95 (i.e., the inner surface of the recessed portion 95) to become negatively charged as shown in Fig. 10C. In other words, the potential on the side wall surfaces 942 of the microstructures 94 becomes lower than the potential in the processing liquid. As a result, plus ions 75 existing around the recessed portion 95 enter the recessed portion 95, and the products 74 trapped in the recessed portion 95 are discharged to the outside of the recessed portion 95.

Thereafter, the polarity of the voltage applied to the first electrode 61 is switched with predetermined timing so that a positive voltage is applied to the first electrode 61. This causes the side wall surfaces 942 of the microstructures 94 (i.e., the inner surface of the recessed portion 95) to become positively charged as shown in Fig. 10D. As a result, the minus ions 73 existing as etchants around the recessed portion 95 enter the recessed portion 95 and come into contact with the processing membrane 96. This accelerates the etching of the processing membrane 96 and increases the etch rate.

Next, a third principle is described. In the above-described etching of the processing membrane 96, a positive voltage and a negative voltage are alternately applied to the first electrode 61. Then, it has been confirmed that air bubbles form inside the recessed portion 95 when one of the positive voltage and the negative voltage is applied, whereas no air bubbles form when the other voltage is applied. Thus, if only the one voltage is continuously applied to the first electrode 61, air bubbles increase in number and become trapped in the recessed portion 95. This lowers the etch rate of the processing membrane 96 or stops the etching of the processing membrane 96. In view of this, the polarity of the voltage applied to the first electrode 61 is switched with predetermined timing so that the air bubbles are discharged to the outside of the recessed portion 95. This prevents air bubbles from inhibiting the etching and thereby increases the etch rate.

Next, a fourth principle is described. The following description is given on the assumption that the processing membrane 96 is a TiN membrane, and the processing liquid used for etching is obtained by adding hydrochloric acid as an electrolytic solution to an aqueous solution of hydrogen peroxide. If a positive voltage is applied to the first electrode 61, chlorine ions (Cl⁻) that serve as ligands in the processing liquid can easily enter the recessed portion 95. This accelerates the etching of the processing membrane 96 and increases the etch rate. As the etching progresses, complexes (Ti-Cl) produced by etching increase in number and become trapped in the recessed portion 95, making it hard for the ligands to enter the recessed portion 95. As a result, the etch rate of the processing membrane 96 is lowered, or the etching of the processing membrane 96 stops.

In view of this, the polarity of the voltage applied to the first electrode 61 is switched with predetermined timing so that a negative voltage is applied to the first electrode 61. This causes the complexes to be discharged to the outside of the recessed portion 95. Thereafter, a positive voltage is applied to the first electrode 61, allowing the ligands in the processing liquid to easily enter the recessed portion 95 as described above. This accelerates the etching of the processing membrane 96 and increases the etch rate.

Note that it has not yet been determined which of the aforementioned first to fourth principles is dominant. There is also a possibility that an increase in the etch rate may be caused by a combination of these principles and other principles, or may be caused by a principle other than the above-described principles. However, in any case, the etching of the processing membrane 96 within the recessed portion 95 can be accelerated by repeatedly switching the applied voltage in the switching cycle of 0.05 seconds or more so that the potential on the side wall surfaces 942 of the microstructures 94 is repeatedly switched between the first potential and the second potential in step S14 described above.

In the substrate processing apparatus 1 shown in Fig. 7, after a predetermined processing time has elapsed since the start of step S14, the supply of the processing liquid from the barrier plate nozzle 51 to the substrate 9 and the application of the voltage from the power source 66 are stopped, and the overall etching of the substrate 9 terminates. In step S14, approximately the entire upper surface 91 of the substrate 9 is etched simultaneously. This shortens the time required for the etching of the substrate 9. Besides, as mentioned above, it is possible to increase the etch rate of the processing membrane 96 approximately across the entire upper surface 91 of the substrate 9.

On the other hand, in step S14, the substrate 9 is rotated at a low speed, and therefore there is almost no movement of the processing liquid on the substrate 9. Thus, the etch rate may vary depending on the position in the radial direction on the substrate 9.

For example, the central portion of the upper surface 91 of the substrate 9 faces the ejection port of the barrier plate nozzle 51 in the up-down direction, but does not face the second electrode 62 in the up-down direction. In other words, the second electrode 62 does not exist vertically above the central portion of the upper surface 91 of the substrate 9. Thus, the etch rate of the central portion of the upper surface 91 of the substrate 9 may become lower than that of regions other than the central portion. Moreover, for example, on the peripheral edge portion of the substrate 9, the temperature of the liquid membrane 50 of the processing liquid may become lower than in regions other than the peripheral edge portion, thereby resulting in a decrease in the etch rate.

In the following description, in the overall etching performed in step S14, a region of the substrate 9 that exhibits a lower etch rate (i.e., a lower amount of etching in step S14) than the other regions is also referred to as a "low-etch-rate region". The low-etch-rate region is known in advance by the operator or the like of the substrate processing apparatus 1. Thus, the controller 8 controls the substrate processing apparatus 1, based on the position of the low-etch-rate region.

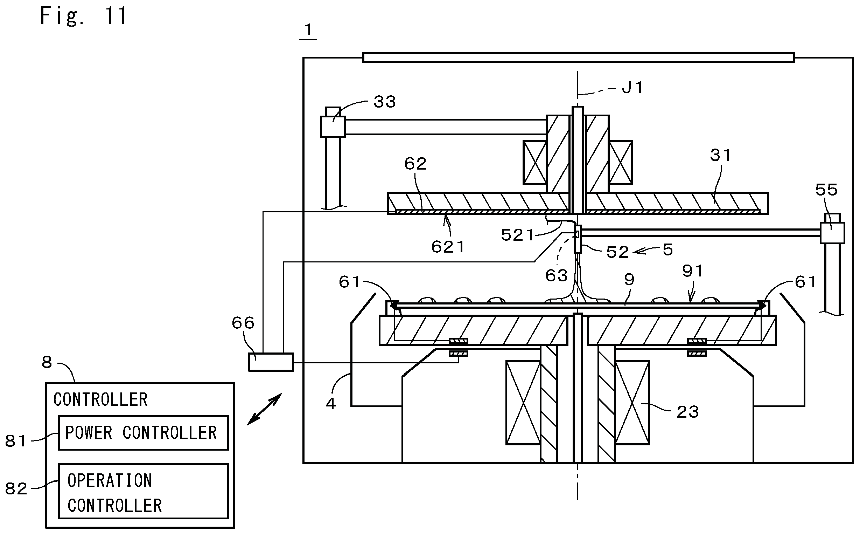

When the overall etching in step S14 ends, the top-plate movement mechanism 33 moves up the top plate 31 from the etching position to a position spaced above from the liquid membrane 50 shown in Fig. 11 (hereinafter, also referred to as the "retracted position"). When the top plate 31 is located at the retracted position, the operation controller 82 controls the nozzle movement mechanism 55 so that the movable nozzle 52 is moved horizontally from the retracted position to a position above the substrate 9. The movable nozzle 52 is located above the aforementioned low-etch-rate region between the substrate 9 and the top plate 31. In the example shown in Fig. 11, the central portion of the upper surface 91 of the substrate 9 corresponds to the low-etch-rate region, and the movable nozzle 52 is located above the central portion of the substrate 9.

Then, the operation controller 82 of the controller 8 controls the processing liquid supplier 5 so that the processing liquid for etching is continuously supplied from the movable nozzle 52 toward the central portion of the upper surface 91 of the substrate 9. This processing liquid comes into contact with the processing membrane 96 (see Fig. 4) on the substrate 9 (step S15). The operation controller 82 also controls the substrate rotation mechanism 23 to increase the rotational frequency of the substrate 9. The rotational frequency of the substrate 9 is, for example, higher than or equal to 10 rpm and preferably in the range of 10 rpm to 1500 rpm. The processing liquid supplied from the movable nozzle 52 onto the substrate 9 spreads radially outward due to centrifugal force caused by the rotation of the substrate 9 and is then scattered radially outward from the peripheral edge of the substrate 9 and received by the cup part 4. In step S15, the processing liquid ejected from the movable nozzle 52 covers the entire low-etch-rate region of the substrate 9. On the other hand, regions other than the low-etch-rate region of the upper surface 91 of the substrate 9 may be exposed from the processing liquid.

Then, the power controller 81 of the controller 8 controls the power source 66 so that a voltage is applied between the first electrode 61 and the third electrode 63. Accordingly, the voltage is applied between the substrate 9 and the processing liquid on the substrate 9. The voltage applied between the substrate 9 and the processing liquid is repeatedly switched between a first voltage and a second voltage different from the first voltage in a predetermined switching cycle under the control of the power controller 81 in approximately the same manner as in step S14. Accordingly, the potential on the side wall surfaces 942 (see Fig. 4) of the microstructures 94 is repeatedly switched between the first potential and the second potential in the aforementioned switching cycle (step S16).

In step S16, a preferable range and waveform of the applied voltage, a preferable range of the switching cycle of the applied voltage, and so on are approximately the same as those in step S14 described above. Note that the first voltage and the second voltage in step S14 may respectively be the same as or different from the first voltage and the second voltage in step S16. The switching cycle and waveform of the applied voltage in step S14 may respectively be the same as or different from the switching cycle and waveform of the applied voltage in step S16.

The switching of the applied voltage in step S16 (i.e., the switching of the potential on the side wall surfaces 942) is continuously performed for a predetermined period of time while the processing liquid is in contact with the processing membrane 96 (see Fig. 4) on the substrate 9. This allows etching (so-called electrolyte etching) to be performed on the low-etch-rate region of the upper surface 91 of the substrate 9 so as to remove the processing membrane 96 on the low-etch-rate region from above the upper surface 91 of the substrate 9. In the following description, the etching performed using the third electrode 63 on the upper surface 91 of the substrate 9 is also referred to as "local etching".

In the local etching in steps S15 and S16, in cases such as where the low-etch-rate region has a relatively large area, the operation controller 82 may control the nozzle movement mechanism 55 so that the movable nozzle 52 ejecting the processing liquid rocks approximately horizontally above the low-etch-rate region. Specifically, for example, the movable nozzle 52 repeatedly moves back and forth between two points on the peripheral edge of the low-etch-rate region, the two points overlapping the path of horizontal movement of the movable nozzle 52 in plan view. The rocking cycle of the movable nozzle 52 (i.e., the time required for one reciprocal movement) is in the range of, for example, 15 seconds to 2700 seconds. The rocking cycle is longer than the aforementioned switching cycle of the applied voltage. The rocking cycle is, for example, 300 times to 600 times of the switching cycle. In the case where the low-etch-rate region has a relatively small area, the movable nozzle 52 does not necessarily have to rock.

The supply of the processing liquid from the movable nozzle 52 and so on in step S15 and the switching of the applied voltage in step S16 are continuously performed for a predetermined period of time while the substrate 9 is being rotated. This allows etching (so-called electrolyte etching) to be performed on the low-etch-rate region, increasing the amount of etching of the low-etch-rate region. As a result, etching uniformity improves across the entire upper surface 91 of the substrate 9.

Although the case where the central portion of the upper surface 91 of the substrate 9 is the low-etch-rate region has been described with reference to Fig. 11, the low-etch-rate region may also be the peripheral edge portion of the upper surface 91 of the substrate 9 as described above. As another alternative, both of the central portion and the peripheral edge portion of the upper surface 91 of the substrate 9 may be low-etch-rate regions. The low-etch-rate region may also be a region other the central portion and the peripheral edge portion of the upper surface 91 of the substrate 9. In any case, steps S15 and S16 are performed while the movable nozzle 52 is located above the low-etch-rate region(s), which increases the amount of etching of the low-etch-rate region(s).

In the substrate processing apparatus 1 shown in Fig. 11, after a predetermined processing time has elapsed since the start of step S16, the supply of the processing liquid from the movable nozzle 52 to the substrate 9 and the application of the voltage from the power source 66 are stopped to stop the local etching performed on the low-etch-rate region(s) of the substrate 9. When the local etching ends, a rinsing liquid is supplied from the movable nozzle 52 to the upper surface 91 of the substrate 9, and the rotational frequency of the substrate 9 is increased.

The rinsing liquid supplied to the substrate 9 spreads across the entire upper surface 91 of the substrate 9 due to centrifugal force caused by the rotation of the substrate 9. Accordingly, rinse processing is performed to wash away the aforementioned processing liquid and so on adhering on the substrate 9 (step S17). The rotational frequency of the substrate 9 in step S17 is, for example, higher than or equal to 800 rpm. The rinsing liquid on the substrate 9 is scattered radially outward from the peripheral edge of the substrate 9 by the centrifugal force caused by the rotation of the substrate 9, and is received by the cup part 4.

After the rinse processing is performed for a predetermined period of time on the substrate 9, the supply of the rinsing liquid is stopped. Thereafter, the rotational speed of the substrate 9 is further increased. Then, the rinsing liquid on the substrate 9 is shaken off and removed, i.e., dry processing is performed on the substrate 9 (step S18). The rotational frequency of the substrate 9 in step S18 is, for example, higher than or equal to 1000 rpm. Note that the dry processing may be performed using any of various known methods. After the dry processing of the substrate 9 ends, the rotation of the substrate 9 is stopped, and the substrate 9 is transported out of the substrate processing apparatus 1.

In the substrate processing apparatus 1, the local etching does not necessarily have to be performed after the overall etching. For example, the overall etching in steps S13 and S14 may be performed after the local etching is performed in steps S15 and S16.

In the substrate processing apparatus 1, the local etching does not necessarily have to be performed on a low-etch-rate region, and may be performed any region that the operator or the like of the substrate processing apparatus 1 considers the local etching necessary. In this case, the movable nozzle 52 is arranged at a desired position in the radial direction above the rotating substrate 9, and the local etching is performed on a partial region corresponding to the desired position on the upper surface 91 of the substrate 9.

The substrate processing apparatus 1 does not necessarily have to switch the applied voltage in both of the overall etching and the local etching. For example, the switching of the applied voltage may be performed in only one of the overall etching and the local etching. Specifically, for example, the aforementioned switching of the applied voltage may be performed in the overall etching in step S13 and S14, and a constant voltage may always be applied between the first electrode 61 and the third electrode 63 in the local etching in steps S15 and S16 without switching of the applied voltage. Alternatively, a constant voltage may always be applied between the first electrode 61 and the second electrode 62 in the overall etching in steps S13 and S14 without switching of the applied voltage, and the aforementioned switching of the applied voltage may be performed in the local etching in steps S15 and S16. As yet another alternative, the switching of the applied voltage is not performed in both of the overall etching and the local etching, and a constant applied voltage may always be applied.

Next, Examples 1 to 28 of the above-described etching of the processing membrane 96 within the recessed portion 95 and Comparative Examples 1 to 3 are described with reference to Tables 1 to 7.

**Table 1**

| | Processing Liquid | Applied Voltage | | | | Amount of Etching (nm) |
|---|---|---|---|---|---|---|
| | | Type | Second Voltage (V) | First Voltage (V) | Switching Cycle (sec) | |
| Example 1 | SC2 | DC | -8 | +8 | 6 | 24 |
| Example 2 | SC2 | DC | -1 | +1 | 6 | 26 |
| Example 3 | SC2 | DC | -0.8 | +0.8 | 6 | 25.5 |
| Example 4 | SC2 | DC | -0.6 | +0.6 | 6 | 25.5 |
| Example 5 | SC2 | DC | -0.5 | +0.5 | 6 | 27.5 |
| Comparative Example 1 | SC2 | - | - | - | - | 11 |

**Table 2**

| | Processing Liquid | Applied Voltage | | | | Amount of Etching (nm) |
|---|---|---|---|---|---|---|
| | | Type | Second Voltage (V) | First Voltage (V) | Switching Cycle (sec) | |
| Example 6 | SC2 | DC | -8 | 0 | 6 | 26 |
| Example 7 | SC2 | DC | -8 | +1 | 6 | 25.5 |
| Example 8 | SC2 | DC | -8 | off | 6 | 25.5 |
| Example 9 | SC2 | DC | -8 | +8 | 6 | 27 |
| Example 10 | SC2 | DC | -1 | +1 | 6 | 25.5 |
| Comparative Example 2 | SC2 | DC | -8 | -2 | 6 | 11 |

**Table 3**

| | Processing Liquid | Applied Voltage | | | | Amount of Etching (nm) |
|---|---|---|---|---|---|---|
| | | Type | Second Voltage (V) | First Voltage (V) | Switching Cycle (sec) | |
| Example 11 | SC2 | DC | -1 | +1 | 2 | 20.5 |
| Example 12 | SC2 | DC | -1 | +1 | 6 | 21.5 |
| Example 13 | SC2 | DC | -1 | +1 | 12 | 22 |
| Example 14 | SC2 | DC | -1 | +1 | 18 | 19.5 |
| Comparative Example 1 | SC2 | - | - | - | - | 11 |

**Table 4**

| | Processing Liquid | Applied Voltage | | | | | Amount of Etching (nm) |
|---|---|---|---|---|---|---|---|
| | | Type | Second Voltage (V) | First Voltage (V) | Frequency (Hz) | Switching Cycle (sec) | |
| Example 15 | SC2 | AC | -1 | +1 | 0.5 | 2 | 21 |
| Example 16 | SC2 | AC | -1 | +1 | 1 | 1 | 22 |
| Example 17 | SC2 | AC | -1 | +1 | 5 | 0.2 | 16.5 |
| Comparative Example 1 | SC2 | - | - | - | - | | 11 |

**Table 5**

| | Processing Liquid | Applied Voltage | | | | Amount of Etching (nm) |
|---|---|---|---|---|---|---|
| | | Type | Second Voltage (V) | First Voltage (V) | Switching Cycle (sec) | |
| Example 18 | H₂O₂ | DC | -1 | +1 | 2 | 18 |
| Example 19 | H₂O₂ | DC | -2 | +2 | 2 | 18.5 |
| Example 20 | H₂O₂ | DC | -3 | +3 | 2 | 19 |
| Example 21 | H₂O₂ | DC | -5 | +5 | 2 | 22.5 |
| Example 22 | H₂O₂ | DC | -8 | +8 | 2 | 24.5 |
| Comparative Example 3 | H₂O₂ | - | - | - | - | 15.5 |

**Table 6**

| | Processing Liquid | Applied Voltage | | | | Amount of Etching (nm) |
|---|---|---|---|---|---|---|
| | | Type | Second Voltage (V) | First Voltage (V) | Switching Cycle (sec) | |
| Example 23 | H₂O₂ | DC | -5 | +5 | 0.5 | 19 |
| Example 24 | H₂O₂ | DC | -5 | +5 | 1 | 21 |
| Example 25 | H₂O₂ | DC | -5 | +5 | 2 | 20 |
| Comparative Example 3 | H₂O₂ | - | - | - | - | 15.5 |

**Table 7**

| | Processing Liquid | Applied Voltage | | | | | Amount of Etching (nm) |
|---|---|---|---|---|---|---|---|
| | | Type | Second Voltage (V) | First Voltage (V) | Frequency (Hz) | Switching Cycle (sec) | |
| Example 26 | H₂O₂ | AC | -5 | +5 | 1 | 1 | 20.5 |
| Example 27 | H₂O₂ | AC | -5 | +5 | 10 | 0.1 | 26 |
| Example 28 | H₂O₂ | AC | -5 | +5 | 20 | 0.05 | 17.5 |
| Comparative Example 3 | H₂O₂ | - | - | - | - | | 15.5 |

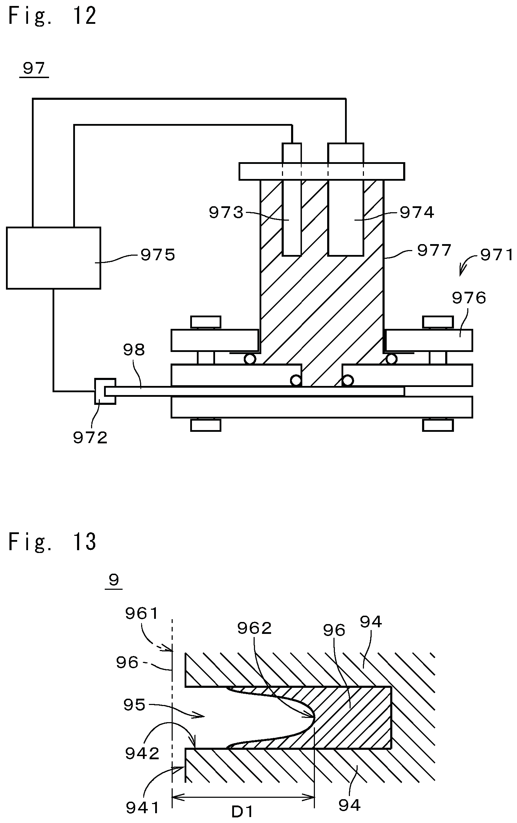

In Examples 1 to 28 and Comparative Example 2, the etching of the processing membrane 96 in the substrate processing apparatus 1 was simulated, and processing corresponding to steps S11 to S18 described above was performed on a test specimen 98 using laboratory equipment 97 shown in Fig. 12. In Comparative Examples 1 and 3, processing corresponding to steps S11 to S13, S15, S17, and S18 described above was performed on a test specimen 98 using the laboratory equipment 97. That is, the application of the voltage in steps S14 and S16 was omitted in Comparative Examples 1 and 3. Note that this processing on the test specimen 98 was conducted in an ambient atmosphere at an ambient temperature (e.g., 25°C).

The laboratory equipment 97 includes an electrolytic cell 971, a test-specimen electrode 972, a counter electrode 973, a reference electrode 974, and a power source 975. As the electrolytic cell 971, "VM-3" manufactured by EC Frontier Co., Ltd. was used. The test specimen 98 was set on a base 976 of the electrolytic cell 971, and a cell cap 977 on the base 976 was filled with a processing liquid for etching. The upper surface of the test specimen 98 was in contact with the processing liquid within the cell cap 977. The area of contact of the test specimen 98 with the processing liquid was defined as 1 cm² by an O-ring. The upper surface of the test specimen 98 was provided with a plurality of microstructures 94 that formed a plurality of recessed portions 95 described above (see Fig. 4).

As the test-specimen electrode 972 corresponding to the above-described first electrode 61 (see Fig. 2), an alligator clip was used. By clipping the end portion of the test specimen 98 with the alligator clip, the test-specimen electrode 972 and the test specimen 98 were electrically connected to each other. As the counter electrode 973, "CE-100" manufactured by EC Frontier Co., Ltd. was used. As the reference electrode 974, "RE-T16" manufactured by EC Frontier Co., Ltd. was used. "RE-T16" was a silver-silver chloride electrode (Ag/AgCl electrode) using a potassium chloride (KCl) solution with a concentration of 3.0 mol/L(mol/L) as an internal solution, and a potential relative to the NHE (normal hydrogen electrode) was +0.208V at 25°C. The counter electrode 973 and the reference electrode 974 were inserted from the upper portion of the cell cap 977 to the interior and came into contact with the processing liquid within the cell cap 977. As the power source 975, "VSP-300-SC" manufactured by Bio-Logic Science instruments SAS and serving as a potentiostat was used.

In Examples 1 to 17 and Comparative Examples 1 and 2 shown in Tables 1 to 4, the processing liquid used in an etching process was SC2, and the processing time for the etching process (i.e., a total processing time in steps S14 and S16) was 60 minutes. The processing liquid was a mixed solution obtained by mixing hydrogen peroxide water with a concentration of about 20 mol%, a hydrochloric acid solution with a concentration of about 22 mol%, and DIW in a volume ratio of 1:1:8.

In Examples 18 to 28 and Comparative Example 3 shown in Tables 5 to 7, the processing liquid used in the etching process was hydrogen peroxide water, and the processing time for the etching process (i.e., a total processing time in steps S14 and S16) was 120 minutes. The processing liquid was a mixed solution obtained by mixing hydrogen peroxide water with a concentration of about 20 mol% and DIW in a volume ratio of 1:8. No other chemical solutions such as hydrochloric acid were added to the processing liquid. That is, the concentration of the hydrochloric acid in the processing liquid was 0 mol% and 0% by mass.

The amount of etching in Tables 1 to 7 was expressed as a distance D1 in the depth direction of the recessed portion 95 (i.e., the right-left direction in Fig. 13) between a surface 961 of the processing membrane 96 before the start of the etching, which was indicated by the chain double-dashed line in Fig. 13, and a surface 962 of the processing membrane 96 after the etching for a predetermined duration in time, which was indicated by the solid line in Fig. 13. As shown in Fig. 13, the distance D1 was a distance between the surface 961 of the processing membrane 96 and the lowest end of the surface 962 of the processing membrane 96 within the recessed portion 95 (i.e., a farthest position in the depth direction from the surface 961). The amount of etching was expressed as an arithmetical mean of distances D1 obtained from six recessed portions 95. These distances D1 were obtained by observing SEM images of cross-sections of the substrate 9.

As described above, in Examples 1 to 17 and Comparative Examples 1 and 2 shown in Tables 1 to 4, SC2 was used as the processing liquid. In Examples 1 to 5 shown in Table 1, the amount of etching of the processing membrane 96 was measured by changing the first and second voltages used as the applied voltage in steps S14 and S16. In Example 1, the voltage applied from the power source 975 was a direct voltage, the second voltage was set to -8V, and the first voltage was set to +8V. The switching cycle of the applied voltage was six seconds. That is, in Example 1, the potential on the side wall surfaces 942 of the microstructures 94 (i.e., the inner surface of the recessed portion 95) was switched between the second potential of -8V and the first potential of +8V in the switching cycle of six seconds. In Example 1, the amount of etching was 24 nm.

Example 2 was the same as Example 1, except that the second voltage was set to -1V, and the first voltage was set to +1V. In Example 2, the potential on the side wall surfaces 942 of the microstructures 94 was switched between the second potential of -1V and the first potential of +1V in the switching cycle of six seconds. In Example 2, the amount of etching was 26 nm.

Example 3 was the same as Example 1, except that the second voltage was set to -0.8V, and the first voltage was set to +0.8V. In Example 3, the potential on the side wall surfaces 942 of the microstructures 94 was switched between the second potential of -0.8V and the first potential of +0.8V in the switching cycle of six seconds. In Example 3, the amount of etching was 25.5nm.

Example 4 was the same as Example 1, except that the second voltage was set to -0.6V, and the first voltage was set to +0.6V. In Example 4, the potential on the side wall surfaces 942 of the microstructures 94 was switched between the second potential of -0.6V and the first potential of +0.6V in the switching cycle of six seconds. In Example 4, the amount of etching was 25.5 nm.

Example 5 was the same as Example 1, except that the second voltage was set to -0.5V, and the first voltage was set to +0.5V. In Example 5, the potential on the side wall surfaces 942 of the microstructures 94 was switched between the second potential of -0.5V and the first potential of +0.5V in the switching cycle of six seconds. In Example 5, the amount of etching was 27.5 nm.

In Comparative Example 1, the application of the voltage in steps S14 and S16 was omitted as described above. In Comparative Example 1, the amount of etching was 11 nm.

A comparison between Examples 1 to 5 and Comparative Example 1 shows that, even if the applied voltage differed, the etch rate of the processing membrane 96 within the recessed portion 95 was increased by performing steps S14 and S16 (the switching of the applied voltage).

In Examples 6 to 10 and Comparative Example 2 shown in Table 2, the amount of etching of the processing membrane 96 was measured by changing the first and second voltages used as the applied voltage in steps S14 and S16. In Example 6, the voltage applied from the power source 975 was a direct voltage, the second voltage was set to -8V, and the first voltage was set to 0V. The switching cycle of the applied voltage was six seconds. That is, in Example 6, the potential on the side wall surfaces 942 of the microstructures 94 (i.e., the inner surface of the recessed portion 95) was switched between the second potential of -8V and the first potential of 0V in the switching cycle of six seconds. In Example 6, the amount of etching was 26 nm.

Example 7 was the same as Example 6, except that the first voltage was set to +1V. In Example 7, the potential on the side wall surfaces 942 of the microstructures 94 was switched between the second potential of -8V and the first potential of +1V in the switching cycle of six seconds. In Example 7, the amount of etching was 25.5 nm.

Example 8 was the same as Example 6, except that the power source 975 was off at the time when the first voltage was scheduled to be applied. When the power source 975 was off, an open-circuit potential on the surface of the test specimen 98 was in the range of +0.6V to +0.8V. In Example 8, the potential on the side wall surfaces 942 of the microstructures 94 was switched between the second potential of -8V and the above open-circuit potential serving as the first potential in the switching cycle of six seconds. In Example 8, the amount of etching was 25.5 nm.

Example 9 was the same as Example 6, except that the first voltage was set to +8V. In Example 9, the potential on the side wall surfaces 942 of the microstructures 94 was switched between the second potential of -8V and the first potential of +8V in the switching cycle of six seconds. In Example 9, the amount of etching was 27 nm.

Example 10 was the same as Example 7, except that the second potential was set to -1V. In Example 10, the potential on the side wall surfaces 942 of the microstructures 94 was switched between the second potential of -1V and the first potential of +1V in the switching cycle of six seconds. In Example 10, the amount of etching was 25.5 nm.

Note that Examples 9 and 10 used the same experimental conditions as Examples 1 and 2 shown in Table 1, but differed in the experiment date or the like. Thus, the amounts of etching differed from those in Examples 1 and 2. In the other examples, if the amount of etching differed even though the experimental conditions were the same, it was because the experiments had been conducted on different days or the like.

Comparative Example 2 was the same as Example 6, except that the first voltage was set to -2V. In Comparative Example 2, the potential on the side wall surfaces 942 of the microstructures 94 was switched between -8V and -2V in the switching cycle of six seconds. In Comparative Example 2, the amount of etching was 11 nm, approximately as in Comparative Example 1 (see Table 1).

A comparison between Examples 6 to 10 and Comparative Example 2 shows that, if the first potential and the second potential on the side wall surfaces 942 were both negative (i.e., had the same sign) in steps S14 and S16 (at the time of switching of the applied voltage) (Comparative Example 2), there was no increase in the etch rate of the processing membrane 96 within the recessed portion 95. On the other hand, in the case where the first potential and the second potential on the side wall surfaces 942 did not have the same sign, even if the absolute value of the first potential was different from the absolute value of the second potential (Examples 6 to 8), the etch rate of the processing membrane 96 within the recessed portion 95 was increased in approximately the same manner as in the case where the first potential and the second potential had the same absolute value (Examples 9 and 10).

Note that Comparative Example 2 was merely a comparative example of the etching of the processing membrane 96 within the recessed portion 95, and it was confirmed that, for the processing membrane 96 on the end faces 941 (see Fig. 4) of the microstructures 94 (i.e., the processing membrane 96 outside the recessed portion 95), the etch rate was increased by applying a voltage as described above as compared with Comparative Example 1 in which no voltage was applied.

In Examples 1 1 to 14 shown in Table 3, the amount of etching of the processing membrane 96 was measured by changing the switching cycle of the applied voltage in steps S14 and S16. In Example 11, the voltage applied from the power source 975 was a direct voltage, the second voltage was set to -1V, and the first voltage was set to +1V. The switching cycle of the applied voltage was two seconds. That is, in Example 11, the potential on the side wall surfaces 942 of the microstructures 94 (i.e., the inner surface of the recessed portion 95) was switched between the second potential of -1V and the first potential of +1V in the switching cycle of two seconds. In Example 11, the amount of etching was 20.5 nm.

Example 12 was the same as Example 11, except that the switching cycle was set to six seconds. In Example 12, the potential on the side wall surfaces 942 of the microstructures 94 was switched between the second potential of -1V and the first potential of +1V in the switching cycle of six seconds. In Example 12, the amount of etching was 21.5 nm.

Example 13 was the same as Example 11, except that the switching cycle was set to 12 seconds. In Example 13, the potential on the side wall surfaces 942 of the microstructures 94 was switched between the second potential of -1V and the first potential of +1V in the switching cycle of 12 seconds. In Example 13, the amount of etching was 22 nm.

Example 14 was the same as Example 11, except that the switching cycle was set to 18 seconds. In Example 14, the potential on the side wall surfaces 942 of the microstructures 94 was switched between the second potential of -1V and the first potential of +1V in the switching cycle of 18 seconds. In Example 14, the amount of etching was 19.5 nm.

In Comparative Example 1, the application of the voltage in steps S14 and S16 was omitted as described above. In Comparative Example 1, the amount of etching was 11 nm as described above.

A comparison between Examples 11 to 14 and Comparative Example 1 shows that, even if the switching cycle differed, the etch rate of the processing membrane 96 within the recessed portion 95 was increased by performing steps S14 and S16 (the switching of the applied voltage).

In Examples 15 to 17 shown in Table 4, the amount of etching of the processing membrane 96 was measured by using an alternating voltage as the applied voltage in steps S14 and S16 and changing the frequency of the alternating voltage (i.e., changing the switching cycle). In Example 15, the voltage applied from the power source 975 was an alternating voltage, the second voltage was set to -1V, and the first voltage was set to +1V. The frequency of the applied voltage was 0.5 Hz (i.e., the switching cycle was two seconds). That is, in Example 15, the potential on the side wall surfaces 942 of the microstructures 94 (i.e., the inner surface of the recessed portion 95) was switched between the second potential of -1V and the first potential of +1V in the switching cycle of two seconds. In Example 15, the amount of etching was 21 nm.

Example 16 was the same as Example 15, except that the frequency was set to 1 Hz (the switching cycle was set to one seconds). In Example 16, the potential on the side wall surfaces 942 of the microstructures 94 was switched between the second potential of -1V and the first potential of +1V in the switching cycle of one seconds. In Example 16, the amount of etching was 22 nm.

Example 17 was the same as Example 15, except that the frequency was set to 5 Hz (the switching cycle was set to 0.2 seconds). In Example 17, the potential on the side wall surfaces 942 of the microstructures 94 was switched between the second potential of -1V and the first potential of +1V in the switching cycle of 0.2 seconds. In Example 17, the amount of etching was 16.5 nm.

In Comparative Example 1, the application of the voltage in steps S14 and S16 was omitted as described above. In Comparative Example 1, the amount of etching was 11 nm as described above.

A comparison between Examples 15 to 17 and Comparative Example 1 shows that, even if the frequency of the alternating voltage differed (i.e., the switching frequency differed), the etch rate of the processing membrane 96 within the recessed portion 95 was increased by performing steps S14 and S16 (the switching of the applied voltage). A comparison between Examples 15 and 11 (Table 3) also shows that, if the same first voltage, the same second voltage, and the same switching cycle were used, the etch rate became approximately the same, irrespective of whether the applied voltage was a direct voltage or an alternating voltage.

In Examples 18 to 28 and Comparative Example 3 shown in Tables 5 to 7, hydrogen peroxide water was used as the processing liquid as described above. In Examples 18 to 22 shown in Table 5, the amount of etching of the processing membrane 96 was measured by changing the first and second voltages used as the applied voltage in steps S14 and S16. In Example 18, the voltage applied from the power source 975 was a direct voltage, the second voltage was set to -1V, and the first voltage was set to +1V. The switching cycle of the applied voltage was two seconds. That is, in Example 18, the potential on the side wall surfaces 942 of the microstructures 94 (i.e., the inner surface of the recessed portion 95) was switched between the second potential of -1V and the first potential of +1V in the switching cycle of two seconds. In Example 18, the amount of etching was 18 nm.

Example 19 was the same as Example 18, except that the second voltage was set to -2V, and the first voltage was set to +2V. In Example 19, the potential on the side wall surfaces 942 of the microstructures 94 was switched between the second potential of -2V and the first potential of +2V in the switching cycle of two seconds. In Example 19, the amount of etching was 18.5 nm.

Example 20 was the same as Example 18, except that the second voltage was set to -3V, and the first voltage was set to +3V. In Example 20, the potential on the side wall surfaces 942 of the microstructures 94 was switched between the second potential of -3V and the first potential of +3V in the switching cycle of two seconds. In Example 20, the amount of etching was 19 nm.

Example 21 was the same as Example 18, except that the second voltage was set to -5V and the first voltage was set to +5V. In Example 21, the potential on the side wall surfaces 942 of the microstructures 94 was switched between the second potential of -5V and the first potential of +5V in the switching cycle of two seconds. In Example 21, the amount of etching was 22.5 nm.

Example 22 was the same as Example 18, except that the second voltage was set to -8V, and the first voltage was set to +8V. In Example 22, the potential on the side wall surfaces 942 of the microstructures 94 was switched between the second potential of -8V and the first potential of +8V in the switching cycle of two seconds. In Example 22, the amount of etching was 24.5 nm.

In Comparative Example 3, the application of the voltage in steps S14 and S16 was omitted as described above. In Comparative Example 3, the amount of etching was 15.5 nm.

A comparison between Examples 18 to 22 and Comparative Example 3 shows that, even if the applied voltage differed, the etch rate of the processing membrane 96 within the recessed portion 95 was increased by performing steps S14 and S16 (the switching of the applied voltage).

In Examples 23 to 25 shown in Table 6, the amount of etching of the processing membrane 96 was measured by changing the switching cycle of the applied voltage in steps S14 and S16. In Example 23, the voltage applied from the power source 975 was a direct voltage, the second voltage was set to -5V, and the first voltage was set to +5V. The switching cycle of the applied voltage was 0.5 seconds. That is, in Example 23, the potential on the side wall surfaces 942 of the microstructures 94 (i.e., the inner surface of the recessed portion 95) was switched between the second potential of -5V and the first potential of +5V in the switching cycle of 0.5 seconds. In Example 23, the amount of etching was 19 nm.

Example 24 was the same as Example 23, except that the switching cycle was set to one seconds. In Example 24, the potential on the side wall surfaces 942 of the microstructures 94 was switched between the second potential of -5V and the first potential of +5V in the switching cycle of one seconds. In Example 24, the amount of etching was 21 nm.

Example 25 was the same as Example 23, except that the switching cycle was set to two seconds. In Example 25, the potential on the side wall surfaces 942 of the microstructures 94 was switched between the second potential of -5V and the first potential of +5V in the switching cycle of two seconds. In Example 25, the amount of etching was 20 nm.

In Comparative Example 3, the application of the voltage in steps S14 and S16 was omitted as described above. In Comparative Example 3, the amount of etching was 15.5 nm as described above.

A comparison between Examples 23 to 25 and Comparative Example 3 shows that, even if the switching cycle differed, the etch rate of the processing membrane 96 within the recessed portion 95 was increased by performing steps S14 and S16 (the switching of the applied voltage).

In Examples 26 to 28 shown in Table 7, the amount of etching of the processing membrane 96 was measured by using an alternating voltage as the applied voltage in steps S14 and S16 and changing the frequency of the alternating voltage (i.e., changing the switching cycle). In Example 26, the voltage applied from the power source 975 was an alternating voltage, the second voltage was set to -5V, and the first voltage was set to +5V. The frequency of the applied voltage was 1 Hz (i.e., the switching cycle was one seconds). That is, in Example 26, the potential on the side wall surfaces 942 of the microstructures 94 (i.e., the inner surface of the recessed portion 95) was switched between the second potential of -5V and the first potential of +5V in the switching cycle of one seconds. In Example 26, the amount of etching was 20.5 nm.

Example 27 was the same as Example 26, except that the frequency was set to 10 Hz (the switching cycle was set to 0.1 seconds). In Example 27, the potential on the side wall surfaces 942 of the microstructures 94 was switched between the second potential of -5V and the first potential of +5V in the switching cycle of 0.1 seconds. In Example 27, the amount of etching was 26 nm.

Example 28 was the same as Example 26, except that the frequency was set to 20 Hz (the switching cycle was set to 0.05 seconds). In Example 28, the potential on the side wall surfaces 942 of the microstructures 94 was switched between the second potential of -5V and the first potential of +5V in the switching cycle of 0.05 seconds. In Example 28, the amount of etching was 17.5 nm.

In Comparative Example 3, the application of the voltage in steps S14 and S16 was omitted as described above. In Comparative Example 3, the amount of etching was 15.5 nm as described above.

A comparison between Examples 26 to 28 and Comparative Example 3 shows that, even if the frequency of the alternating voltage differed (i.e., the switching cycle differed), the etch rate of the processing membrane 96 within the recessed portion 95 was increased by performing steps S14 and S16 (the switching of the applied voltage). A comparison between Examples 26 and 24 (Table 6) also shows that, if the same first voltage, the same second voltage, and the same switching cycle were used, the etch rate became approximately the same, irrespective of whether the applied voltage was a direct voltage or an alternating voltage.

As described thus far, the substrate processing apparatus 1 includes the substrate holder 21, the substrate rotation mechanism 23, the processing liquid supplier 5, the barrier plate (i.e., the top plate 31), the barrier-plate movement mechanism (i.e., the top-plate movement mechanism 33), the first electrode 61, the second electrode 62, the third electrode 63, and the power source 66. The substrate holder 21 holds a substrate 9 in a horizontal position, the substrate having the upper surface 91 on which the processing membrane 96 is provided. The substrate rotation mechanism 23 rotates the substrate holder 21 about the central axis J1 extending in the up-down direction. The processing liquid supplier 5 supplies a processing liquid for etching to the upper surface 91 of the substrate 9 to bring the processing liquid into contact with the processing membrane 96. The top plate 31 extends across the entire upper surface 91 of the substrate 9 and faces the upper surface 91 of the substrate 9 in the up-down direction. The top-plate movement mechanism 33 moves the top plate 31 relative to the substrate 9 in the up-down direction. The first electrode 61 is electrically connected to the substrate 9. The second electrode 62 is electrically connected to the processing liquid. The third electrode 63 is electrically connected to the processing liquid. The power source 66 is capable of applying a voltage between the first electrode 61 and the second electrode 62 and between the first electrode 61 and the third electrode 63.

The processing liquid supplier 5 includes the barrier plate nozzle 51, the movable nozzle 52, and the nozzle movement mechanism 55. The barrier plate nozzle 51 is fixedly attached to the top plate 31 and ejects a processing liquid from the lower surface 311 of the top plate 31 toward the upper surface 91 of the substrate 9. The movable nozzle 52 ejects a processing liquid from above the substrate 9 toward the upper surface 91 of the substrate 9. The nozzle movement mechanism 55 horizontally moves the movable nozzle 52 above the substrate 9. When the liquid membrane 50 is formed as a result of the processing liquid filling a gap between the lower surface 311 of the top plate 31 and the upper surface 91 of the substrate 9, the second electrode 62 provided on the lower surface 311 of the top plate 31 is electrically connected to the processing liquid in direct contact with the liquid membrane 50. The third electrode 63 is electrically connected to the processing liquid ejected from the movable nozzle 52.

This allows the substrate processing apparatus 1 to perform both of the overall etching on the entire upper surface of the substrate 9 and the local etching on a desired region (e.g., a low-etch-rate region) of the upper surface 91 of the substrate 9. As a result, as described above, it is possible to shorten the time required for the etching of the substrate 9 and to improve etching uniformity across the entire upper surface 91 of the substrate 9.

As described above, the substrate processing apparatus 1 further includes the controller 8. The controller 8 controls the substrate rotation mechanism 23, the processing liquid supplier 5, the top-plate movement mechanism 33, and the power source 66. In the substrate processing apparatus 1, it is preferable that, under the control of the controller 8, when the liquid membrane 50 is formed as a result of the gap between the lower surface 311 of the top plate 31 and the upper surface 91 of the substrate 9 being filled with the processing liquid supplied from the barrier plate nozzle 51, the overall etching is performed on the entire upper surface 91 of the substrate 9 by applying a voltage between the first electrode 61 and the second electrode 62. It is also preferable that, under the control of the controller 8, when the top plate 31 is retracted to a position above the substrate 9 and the movable nozzle 52 is arranged at a desired position in the radial direction above the rotating substrate 9 (in the above-described example, above a low-etch-rate region), the local etching is performed on a partial region (in the above-described example, a low-etch-rate region) of the upper surface 91 of the substrate 9 by applying a voltage between the first electrode 61 and the third electrode 63 while ejecting the processing liquid from the movable nozzle 52. This shortens the time required for the etching of the substrate 9 and favorably improves etching uniformity across the entire upper surface 91 of the substrate 9.

As described above, in the substrate processing apparatus 1, it is preferable that the local etching is performed after the overall etching is performed on the substrate 9 under the control of the controller 8. Accordingly, the processing membrane 96 is removed to some extent from the low-etch-region or the like by the overall etching and thereafter further removed by the local etching. This improves the efficiency of removing the processing membrane 96 by the local etching. As a result, it is possible to improve etching uniformity across the entire upper surface 91 of the substrate 9 favorably and efficiently.

As described above, it is preferable that the local etching is performed on a central portion of the substrate 9 in the radial direction. This improves etching uniformity across the entire upper surface 91 of the substrate 9 even if the overall etching gives a low etch rate of the central portion of the substrate 9 due to being faced with the barrier plate nozzle 51 or the like (i.e., non-existence of the opposing second electrode 62).

As described above, it is also preferable that the local etching is performed on a peripheral edge portion of the substrate 9. This improves etching uniformity across the entire upper surface 91 of the substrate 9 even if the overall etching gives a low etch rate of the peripheral edge portion of the substrate 9 due to a drop in the temperature of the processing liquid or the like.

As described above, preferably in at least one of the overall etching and the local etching, the voltage applied between the first electrode 61 and the second or third electrode 62 or 63 is repeatedly switched between the first voltage and the second voltage different from the first voltage in a predetermined switching cycle, so that the potential on the side wall surfaces 942, which form the recessed portion 95 in the pattern 93 on the substrate 9, is repeatedly switched between the first potential and the second potential lower than the first potential. The aforementioned first potential is higher than or equal to 0V, and the second potential is lower than or equal to 0V. This increase the etch rate of the processing membrane 96 located within the recessed portion 95 as illustrated in Examples 1 to 28. The reason for the increase in the etch rate can, for example, be considered as follows.

According to the above-described first principle, water molecules or the like adsorbing onto the surface of the processing membrane 96 within the recessed portion 95 can favorably be electrolyzed by repeatedly switching the potential on the side wall surfaces 942. This allows an etchant such as hydrogen peroxide to favorably adsorb onto the processing membrane 96. As a result, it is possible to increase the etch rate of the processing membrane 96.

According to the above-described second principle, product that have been generated by etching and increased in number in the recessed portion 95 (hereinafter, also referred to as "etching products") can favorably be discharged to the outside of the recessed portion 95 by repeatedly switching the potential on the side wall surfaces 942. As a result, the etchant can easily enter the recessed portion 95. This increases the etch rate of the processing membrane 96.

According to the above-described third principle, air bubbles that have formed in the recessed portion 95 can favorably be discharged to the outside of the recessed portion 95 by repeatedly switching the potential on the side wall surfaces 942. As a result, an etchant can easily enter the recessed portion 95. This increases the etch rate of the processing membrane 96.

According to the above-described fourth principle, complexes that have been produced by etching and increased in number within the recessed portion 95 can favorably be discharged to the outside of the recessed portion 95 by repeatedly switching the potential on the side wall surfaces 942. As a result, an etchant can easily enter the recessed portion 95. This increases the etch rate of the processing membrane 96.

As described above, the switching cycle of the applied voltage is preferably more than or equal to 0.05 seconds. This further increases the etch rate of the processing membrane 96 located within the recessed portion 95. The reason for the further increase in the etch rate can, for example, be considered as follows.

According to the above-described first principle, if the switching cycle is less than 0.05 seconds, the applied voltage may be switched before water molecules or the like adsorbing on the surface of the processing membrane 96 are fully electrolyzed sufficiently, and accordingly the electrolysis of the water molecules or the like may become insufficient. This incurs the risk of inhibiting the adsorption of the etchant onto the processing membrane 96 due to the presence of water molecules or the like and resulting in an insufficient increase in the etch rate. On the other hand, if the switching cycle is more than or equal to 0.05 seconds, the electrolysis of water molecules or the like can favorably be conducted, which further increases the etch rate of the processing membrane 96.

According to the above-described second principle, if the switching cycle is less than 0.05 seconds, the applied voltage may be switched before the etching products are fully discharged to the outside of the recessed portion 95, and accordingly the discharge of the etching products to the outside of the recessed portion 95 may become insufficient. This incurs the risk of inhibiting the entry of the etchant into the recessed portion 95 and resulting in an insufficient increase in the etch rate. On the other hand, if the switching cycle is more than or equal to 0.05 seconds, the etching products can favorably be discharged to the outside of the recessed portion 95, which further increases the etch rate of the processing membrane 96.

According to the above-described third principle, if the switching cycle is less than 0.05 seconds, the applied voltage may be switched before air bubbles are fully discharged to the outside of the recessed portion 95, and accordingly the discharge of air bubbles to the outside of the recessed portion 95 may become insufficient. This incurs the risk of inhibiting the entry of the etchant into the recessed portion 95 and resulting in an insufficient increase in the etch rate. On the other hand, if the switching cycle is more than or equal to 0.05 seconds, air bubbles can favorably be discharged to the outside of the recessed portion 95, which further increases the etch rate of the processing membrane 96.

According to the above-described fourth principle, if the switching cycle is less than 0.05 seconds, the applied voltage may be switched before complexes are fully discharged to the outside of the recessed portion 95, and accordingly the discharge of the complexes to the outside of the recessed portion 95 may become insufficient. This incurs the risk of inhibiting the entry of the etchant into the recessed portion 95 and resulting in an insufficient increase in the etch rate. On the other hand, if the switching cycle is more than or equal to 0.05 seconds, the complexes can favorably be discharged to the outside of the recessed portion 95, which further increases the etch rate of the processing membrane 96.

As described above, in the case where the applied voltage is a direct voltage, the switching cycle is preferably more than or equal to 0.5 seconds. This allows a favorable increase in the etch rate of the processing membrane 96.

As described above, in the case where the applied voltage is an alternating voltage, the switching cycle is preferably more than or equal to 0.2 seconds. This allows a favorable increase in the etch rate of the processing membrane 96.

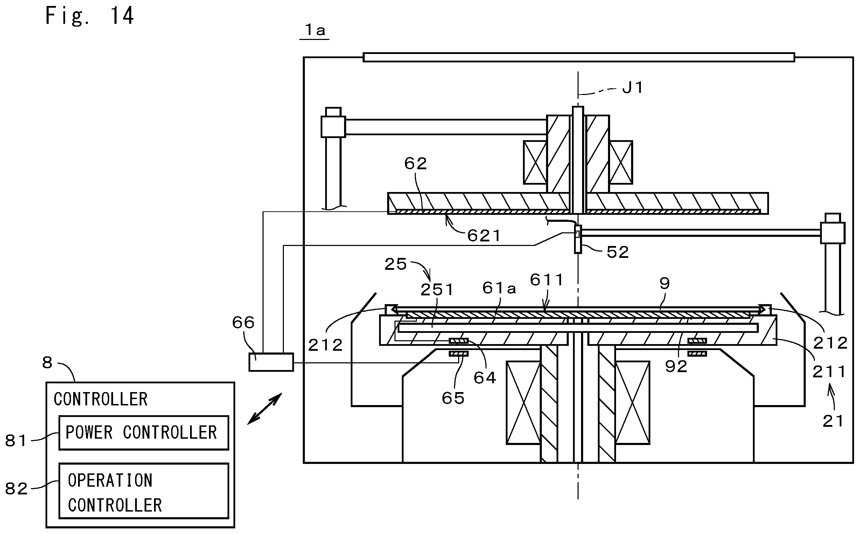

The configuration of the substrate processing apparatus 1 is not limited to the above-described examples, and may be modified in various ways. For example, a substrate processing apparatus 1a shown in Fig. 14 includes a first electrode 61a arranged in the upper surface of the base part 211 of the substrate holder 21, instead of the multiple first electrodes 61 provided on the multiple chuck points 212 (see Fig. 2). The first electrode 61a is an approximately annular plate-like or disc-like conductive member centered on the central axis J1. Just as with the first electrodes 61 described above, the first electrode 61a is formed of, for example, platinum (Pt) or glassy carbon (GC). In plan view, for example, the outside diameter of the first electrode 61a is slightly smaller than the diameter of the substrate 9. Note that the outside diameter of the first electrode 61a may be greater than or approximately the same as the diameter of the substrate 9 in plan view. Just as with the multiple first electrodes 61 described above, the first electrode 61a is electrically connected to the power source 66 via the first transmitter 64 and the second transmitter 65. Note that the shape, material, or the like of the first electrode 61a may be changed in various ways.

An upper surface 611 of the first electrode 61a is not covered with the base part 211 and is exposed from the upper surface of the base part 211. The upper surface 611 of the first electrode 61a extends approximately across the entire lower surface 92 of the substrate 9 and faces the lower surface 92 in direct face-to-face contact in the up-down direction. Thus, the first electrode 61a is electrically connected to the substrate 9. The upper surface 611 of the first electrode 61a extends approximately across the entire lower surface 621 of the second electrode 62 and faces the lower surface 621 in the up-down direction with the substrate 9 sandwiched therebetween.

In the substrate processing apparatus 1a, the first electrode 61a is provided over a relatively wide range in face-to-face contact with the lower surface 92 of the substrate 9. This alleviates the concentration of current on the peripheral edge portion of the substrate 9 during the overall etching in steps S13 and S14, as compared with the case of the substrate processing apparatus 1 in which the first electrodes 61 are electrically connected to only the peripheral edge portion of the substrate 9. Moreover, during the local etching in steps S15 and S16, the lower end of the movable nozzle 52 and the first electrode 61a face each other in the up-down direction with the substrate 9 sandwiched therebetween, regardless of the position of the movable nozzle 52. Thus, the local etching is performed favorably, regardless of the position of the movable nozzle 52. This suppresses variations in the potential on the processing membrane 96 (see Fig. 4) depending on the position in the radial direction on the substrate 9.

The first electrode 61a also comes into direct contact with the substrate 9 along the entire circumference centered on the central axis J1. This also suppresses variation in the potential on the processing membrane 96 depending on the position in the circumferential direction on the substrate 9 (e.g., in the case of the substrate processing apparatus 1, the angle formed between the chuck pins 21 in the circumferential direction). As a result, it is possible to improve uniformity in the etch rate of the substrate 9 in both the radial direction and the circumferential direction.

In the substrate processing apparatus 1a, the first electrode 61a may be movable relative to the base part 211 in the up-down direction. In this case, when the substrate 9 is transported into the substrate processing apparatus 1a and held by the substrate holder 21, the first electrode 61a may be spaced below from the substrate 9, and after the substrate 9 is held by the multiple chuck pins 212, the first electrode 61a may be moved up relative to the base part 211 to come into direct contact with the lower surface 92 of the substrate 9. A mechanism for moving the first electrode 61a relative to the base part 211 in the up-down direction may, for example, be an electric linear motor, an air cylinder, or a combination of a ball screw and an electric rotary motor, any of which is connected to the first electrode 61a.

As described above, the substrate processing apparatus 1a includes the first electrode 61a that is provided in the upper surface of the base part 211 and comes in face-to-face contact with the lower surface 92 of the substrate 9. This further improves uniformity in the etch rate of the substrate 9.

Note that the substrate processing apparatus 1a may include the multiple first electrodes 61 (see Fig. 2) arranged respectively on the upper inner side faces 213 of the multiple chuck pins 212, in addition to the first electrode 61a described above. In this case, just as with the first electrode 61a, the multiple first electrodes 61 are electrically connected to the power source 66 via the first transmitter 64 and the second transmitter 65. In steps S14 and S16, the multiple first electrodes 61 are set to the same potential as the first electrode 61a by applying a voltage from the power source 66.

As shown in Fig. 14, the substrate processing apparatus 1a may include a heater 25 that heats the substrate 9 from the underside. The heater 25 includes a hot plate 251 arranged inside the base part 211 of the substrate holder 21. The hot plate 251 is arranged below the first electrode 61a provided in the upper surface of the base part 211. In other words, the first electrode 61a is arranged between the hot plate 251 built in the base part 211 and the lower surface 92 of the substrate 9.

The hot plate 251 is an approximately annular plate-like or disc-like member centered on the central axis J1. For example, the outside diameter of the hot plate 251 is slightly smaller than the diameter of the substrate 9. The hot plate 251 is an electric heater with heating wires (not shown) embedded in the interior of a hot-plate body. The hot plate body formed of ceramics or the like is increased in temperature by supplying electric power to the heating wires.

In the substrate processing apparatus 1a, during the overall etching and the local etching in steps S13 to S16, the hot plate 251 arranged below the first electrode 61a comes into indirect contact with the lower surface 92 of the substrate 9 via the first electrode 61a. The substrate 9 is heated from the underside by the hot plate 251 via the first electrode 61a. The first electrode 61a is preferably formed of a material with relatively high thermal conductivity, such as glassy carbon.

In the substrate processing apparatus 1a, the temperature of the processing membrane 96 (see Fig. 4) is increased as a result of the substrate 9 being heated by the heater 25. This increases the etch rate of the processing membrane 96. Since the electric resistance of the substrate 9 decreases with increasing temperature, the applied voltage required to accelerate the etching can be lowered by heating the substrate 9. During the overall etching and the local etching in steps S13 to S16, the temperature of the upper surface 91 of the substrate 9 is preferably set in the range of, for example, 40°C to 100°C.

In the etching of the substrate 9, the etch rate may vary depending on the position in the radial direction on the substrate 9 as described above. In view of this, in the substrate processing apparatus 1a, the operation controller 82 may control the heater 25 so that the temperature of the hot plate 251 is changed depending on the position in the radial direction. In other words, as a result of the heater 25 being controlled by the operation controller 82, the amount of heat applied per unit area of the lower surface 92 of the substrate 9 from the hot plate 251 can be changed depending on the distance in the radial direction from the central axis J1 on the substrate 9.

Specifically, for example, the hot plate body of the hot plate 251 includes a plurality of heating wires arranged approximately concentrically about the central axis J1. Electric power supplied to these heating wires can be controlled independently. By adjusting the electric power supplied to each of the multiple heating wires of the hot plate 251, the temperature of the hot plate 251 can be adjusted for each position in the radial direction. Accordingly, the amount of heat applied per unit area of the lower surface 92 of the substrate 9 from the hot plate 251 can be adjusted for each position in the radial direction.

In the substrate processing apparatus 1a, for example, if the etch rate of the peripheral edge portion of the substrate 9 becomes lower than the etch rate of the central portion of the substrate 9 as a result of uniform heating of the substrate 9, the heater 25 is controlled such that the temperature on the peripheral edge portion of the hot plate 251 becomes higher than the temperature on the central position of the hot plate 251. This improves uniformity in the etch rate of the substrate 9 in the radial direction.

As described above, the substrate processing apparatus 1a further includes the heater 25 that heats the substrate 9 from the underside. Therefore, the etch rate of the processing membrane 96 can be increased by increasing the temperature of the substrate 9.

As described above, the heater 25 is preferably capable of changing the amount of heat applied per unit area of the lower surface 92 of the substrate 9 depending on the distance from the center of the substrate 9 (i.e., the central axis J1). This improves uniformity in the etch rate of the substrate 9 in the radial direction.

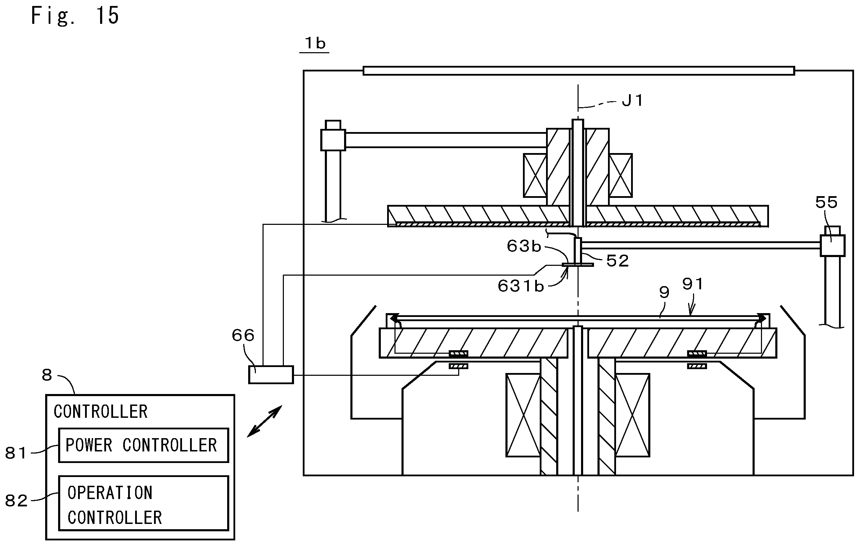

A substrate processing apparatus 1b shown in Fig. 15 includes, instead of the third electrode 63 (see Fig. 2), a third electrode 63b that is provided on the movable nozzle 52 and has a different shape from the third electrode 63. The third electrode 63b is mechanically connected and fixedly attached to a lower end portion of the movable nozzle 52. For example, the third electrode 63b is an approximately annular and flat plate-like conductive member centered on the movable nozzle 52. In other words, the lower end portion of the movable nozzle 52 is located at the central portion of the third electrode 63b in plan view. For example, the third electrode 63b fits in the lower end portion of the movable nozzle 52. The third electrode 63b is moved horizontally together with the movable nozzle 52 by the nozzle movement mechanism 55, and moved together with the movable nozzle 52 in the up-down direction.

In the example shown in Fig. 15, the lower end of the movable nozzle 52 is located at approximately the same position as a lower surface 631b of the third electrode 63b in the up-down direction. The ejection port located at the lower end of the movable nozzle 52 is located at an opening provided in a central portion of the lower surface 631b of the third electrode 63b and faces the upper surface 91 of the substrate 9 in the up-down direction. Note that the lower end of the movable nozzle 52 may be located below the lower surface 631b of the third electrode 63b, or may be located above the lower surface 631b of the third electrode 63b.

In plan view, the third electrode 63b is smaller than the upper surface 91 of the substrate 9. In other words, the outside diameter of the third electrode 63b is smaller than the diameter of the substrate 9. In the case where the substrate 9 has a diameter of 300 mm, the outside diameter of the third electrode 63b is in the range of, for example, 20 mm to 100 mm. The lower surface 631b of the third electrode 63b extends approximately across the entire lower surface 631b and faces the upper surface 91 of the substrate 9 in the up-down direction. The lower surface 631b of the third electrode 63b is a flat surface that is approximately parallel to the upper surface 91 of the substrate 9.

Just as with the third electrode 63 (see Fig. 2), the third electrode 63b is mechanically and electrically connected to the power source 66 via an electric wire. Just as with the third electrode 63, the third electrode 63b is formed of a material with high chemical resistance and high conductivity. For example, the third electrode 63b is formed of platinum or glassy carbon. Note that the shape, material, and so on of the third electrode 63b may be changed in various ways.

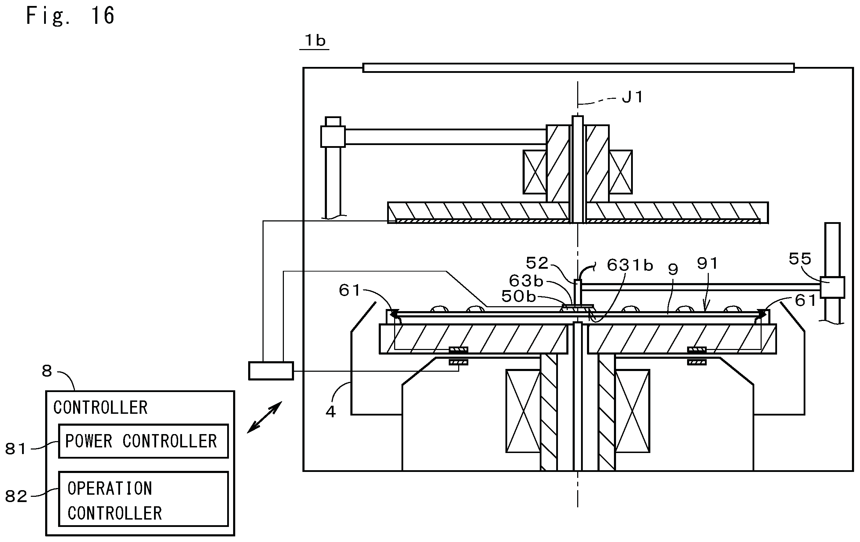

A procedure for processing performed on a substrate 9 by the substrate processing apparatus 1b is approximately the same as the processing performed in steps S11 to S18 shown in Fig. 5, except that the movable nozzle 52 is located at a different position in the up-down direction during the local etching in steps S15 and S16. In the substrate processing apparatus 1b, after the ejection of the processing liquid from the movable nozzle 52 is started in step S15, the nozzle movement mechanism 55 moves down the movable nozzle 52 and the third electrode 63b so as to come into close proximity to the substrate 9 in the up-down direction as shown in Fig. 16. In the following description, the positions of the movable nozzle 52 and the third electrode 63b in the up-down direction shown in Fig. 16 are also referred to as "etching positions".

When the movable nozzle 52 and the third electrode 63b are located at the etching positions, the lower surface 631b of the third electrode 63b is slightly spaced above from the upper surface 91 of the rotating substrate 9. The distance in the up-down direction between the lower surface 631b of the third electrode 63b and the upper surface 91 of the substrate 9 is, for example, about 4 mm. For example, the lower surface 631b of the third electrode 63b faces a low-etch-rate region of the upper surface 91 of the substrate 9 in the up-down direction.

Approximately the entire gap between the lower surface 631b of the third electrode 63b and the upper surface 91 of the substrate 9 is filled with the processing liquid ejected continuously from the movable nozzle 52, so that a liquid membrane 50b of the processing liquid is formed. For example, the liquid membrane 50b is formed approximately across the entire lower surface 631b of the third electrode 63b. The third electrode 63b comes into direct contact with the upper surface of the liquid membrane 50b and is thereby electrically connected to the processing liquid for etching that forms the liquid membrane 50b (i.e., the processing liquid ejected from the movable nozzle 52). Note that the movable nozzle 52 may rock approximately horizontally above the low-etch-rate region.

Part of the processing liquid supplied from the movable nozzle 52 to the substrate 9 is scattered radially outward from the peripheral edge of the substrate 9 by centrifugal force caused by the rotation of the substrate 9, and is received by the cup part 4. The rotational frequency of the substrate 9 in steps S15 and S16 is, for example, higher than or equal to 10 rpm and preferably in the range of 10 rpm to 1500 rpm.

When the movable nozzle 52 is located at the etching position, approximately the entire upper surface 91 of the substrate 9 may be covered with the processing liquid for etching. Or, in cases such as where the upper surface 91 of the substrate 9 has high hydrophobicity, the processing liquid may be interrupted so that the upper surface 91 is exposed to the atmosphere in a region of the upper surface 91 of the substrate 9 that does not overlap with the third electrode 63b in plan view.

In step S16, a voltage is applied between the first electrode 61 and the third electrode 63b. Accordingly, the voltage is applied between the substrate 9 and the processing liquid beneath the third electrode 63b (i.e., the processing liquid on the low-etch-rate region). For example, the voltage applied between the substrate 9 and the processing liquid is repeatedly switched between the first voltage and the second voltage different from the first voltage in a predetermined switching cycle in approximately the same manner as described above. Accordingly, in the low-etch-rate region, the potential on the side wall surfaces 942 of the microstructures 94 (see Fig. 4) is repeatedly switched between the first potential and the second potential in the aforementioned switching cycle. As a result, the etch rate of the processing membrane 96 within the recessed portion 95 is increased in the low-etch-rate region.

In the substrate processing apparatus 1b, when steps S15 and S16 end, the movable nozzle 52 and the third electrode 63b are moved up from the etching positions and located at, for example, the positions shown in Fig. 15. Then, as described above, rinse processing and dry processing (steps S17 and S18) are performed, and the processing on the substrate 9 terminates.

As described above, in the substrate processing apparatus 1b, the third electrode 63b is mechanically connected to the lower end portion of the movable nozzle 52 and faces the upper surface 91 of the substrate 9 in the up-down direction. The third electrode 63b is a flat plate-like member smaller than the upper surface 91 of the substrate 9. In the substrate processing apparatus 1b, the local etching is performed while the liquid membrane 50b is formed as a result of the gap between the lower surface 631b of the third electrode 63b and the upper surface 91 of the substrate 9 being filled with the processing liquid. The substrate processing apparatus 1b can increase the area of the substrate 9 where the local etching is performed simultaneously, as compared to the case where the third electrode 63b is not provided on the lower end portion of the movable nozzle 52. As a result, it is possible to shorten the time required for the local etching.

The substrate processing apparatuses 1, 1a, and 1b described above may be modified in various ways.

For example, the local etching performed by the substrate processing apparatus 1 does not necessarily have to be performed on the central portion or the peripheral edge portion of the substrate 9, and may be performed on a desired position in the radial direction on the substrate 9. The number of desired positions may be just one, or it may be two or more. The same also applies to the substrate processing apparatuses 1a and 1b.

In the rinse processing performed in step S17 in the substrate processing apparatus 1, the rinsing liquid may be supplied from a different nozzle other than the movable nozzle 52 to the upper surface 91 of the substrate 9. The same also applies to the substrate processing apparatuses 1a and 1b.

In the substrate processing apparatus 1, the electrical connection between the first electrode 61 and the power source 66 does not necessarily have to be established without physical contact. For example, the first electrode 61 and the power source 66 may be mechanically and electrically connected to each other via a slip ring or the like provided on the shaft 217. Approximately the same also applies to the substrate processing apparatuses 1a and 1b. In this case, the first transmitter 64 and the second transmitter 65 may be omitted.

In the substrate processing apparatus 1, the second electrode 62 may be electrically connected to the power source 66 without physical contact via a wireless feeder device or the like using a magnetic coupling system or an electric-field coupling system as described above. The same also applies to the substrate processing apparatuses 1a and 1b.

In the substrate processing apparatus 1, the aforementioned switching cycle of the applied voltage may be less than 0.05 seconds. Moreover, the substrate processing apparatus 1 does not necessarily have to switch the applied voltage as described above, and the applied voltage may be always constant during both of the overall etching and the local etching. Approximately the same also applies to the substrate processing apparatuses 1a and 1b.

The substrate holder 21 does not necessarily have to be a mechanical chuck and may have any of other various structures. For example, the substrate holder 21 may be a vacuum chuck that adsorbs onto and holds the substrate 9 in direct face-to-face contact with the lower surface 92 of the substrate 9. In this case, for example, the upper surface of the vacuum chuck that comes into contact with the lower surface 92 of the substrate 9 may serve as an approximately disc-like first electrode, and the substrate 9 and the first electrode may be electrically connected to each other by the first electrode coming into direct face-to-face contact with the lower surface 92 of the substrate 9.

The substrate processing apparatuses 1, 1a, and 1b described above may be used to process not only semiconductor substrates, but also glass substrates that are used in flat panel displays such as liquid crystal displays or organic electro luminescence (EL) displays, or glass substrates that are used in other display devices. The substrate processing apparatuses 1, 1a, and 1b described above may also be used to process other substrates such as optical-disc substrates, magnetic-disc substrates, magneto-optical-disc substrates, photomask substrates, ceramic substrates, or substrates for solar cells.

The configurations according to the above-described embodiment and variations may appropriately be combined as long as there are no mutual inconsistencies.

While the invention has been shown and described in detail, the foregoing description is in all aspects illustrative and not restrictive. It is therefore understood that numerous modifications and variations can be devised without departing from the scope of the invention.

### REFERENCE SIGNS LIST

- 1, 1a, 1b: substrate processing apparatus
- 5: processing liquid supplier
- 8: controller
- 9: substrate
- 21: substrate holder
- 23: substrate rotation mechanism
- 25: heater
- 31: top plate
- 33: top-plate movement mechanism
- 50, 50b: liquid membrane
- 51: barrier plate nozzle
- 52: movable nozzle
- 55: nozzle movement mechanism
- 61, 61a: first electrode
- 62: second electrode
- 63, 63b: third electrode
- 66: power source
- 91: upper surface (of the substrate)
- 96: processing membrane
- 311: lower surface (of the top plate)
- 621: lower surface (of the second electrode)
- 631b: lower surface (of the third electrode)
- J1: central axis

## Claims

1. A substrate processing apparatus (1) that performs etching on a substrate (9), the substrate processing apparatus (1) comprising:
a substrate holder (21) that holds a substrate (9) in a horizontal position, the substrate (9) having an upper surface (91) on which a processing membrane (96) is provided;
a substrate rotation mechanism (23) that rotates said substrate holder (21) about a central axis (J1) extending in an up-down direction;
a processing liquid supplier (5) that supplies a processing liquid for etching to said upper surface (91) of said substrate (9) to bring said processing liquid into contact with said processing membrane (96);
a barrier plate (31) that extends across an entirety of said upper surface (91) of said substrate (9) and faces said upper surface (91) of said substrate (9) in the up-down direction;
a barrier-plate movement mechanism (33) that moves said barrier plate (31) relative to said substrate (9) in the up-down direction;
a first electrode (61) that is electrically connected to said substrate (9);
a second electrode (62) and a third electrode (63) that are electrically connected to said processing liquid; and
a power source (66) capable of applying a voltage between said first electrode (61) and said second electrode (62) and between said first electrode (61) and said third electrode (63),
wherein said processing liquid supplier (5) includes:
a barrier plate nozzle (51) that is fixedly attached to said barrier plate (31) to eject said processing liquid from a lower surface (311) of said barrier plate (31) toward said upper surface (91) of said substrate (9);
a movable nozzle (52) that ejects said processing liquid from above said substrate (9) toward said upper surface (91) of said substrate (9); and
a nozzle movement mechanism (55) that horizontally moves said movable nozzle (52) above said substrate (9),
when a liquid membrane (50) is formed as a result of said processing liquid filling a gap between said lower surface (311) of said barrier plate (31) and said upper surface (91) of said substrate (9), said second electrode (62) provided on said lower surface (311) of said barrier plate (31) is electrically connected to said processing liquid in direct contact with said liquid membrane (50), and
said third electrode (63) is electrically connected to said processing liquid ejected from said movable nozzle (52).

2. The substrate processing apparatus (1) according to claim 1, further comprising:
a controller (8) that controls said substrate rotation mechanism (23), said processing liquid supplier (5), said barrier-plate movement mechanism (33), and said power source (66),
wherein, under control of said controller (8), overall etching is performed on an entirety of said upper surface (91) of said substrate (9) by applying a voltage between said first electrode (61) and said second electrode (62) while said liquid membrane (50) of said processing liquid supplied from said barrier plate nozzle (51) is formed in the gap between said lower surface (311) of said barrier plate (31) and said upper surface (91) of said substrate (9), and
under control of said controller (8), local etching is performed on a partial region of said upper surface (91) of said substrate (9) by applying a voltage between said first electrode (61) and said third electrode (63) as well as ejecting said processing liquid from said movable nozzle (52) while said barrier plate (31) is retracted to a position above said substrate (9), and said movable nozzle (52) is arranged at a desired position in a radial direction above said substrate (9) that is being rotated.

3. The substrate processing apparatus (1) according to claim 2, wherein
under control of said controller (8), said local etching is performed on said substrate (9) after said overall etching is performed.

4. The substrate processing apparatus (1) according to claim 2 or 3, wherein
said local etching is performed on a central portion of said substrate (9) in the radial direction.

5. The substrate processing apparatus (1) according to any one of claims 2 to 4, wherein
said local etching is performed on a peripheral edge portion of said substrate (9).

6. The substrate processing apparatus (1b) according to any one of claims 2 to 5, wherein
said third electrode (63b) is a flat plate-like member smaller than said upper surface (91) of said substrate (9), the third electrode (63b) being mechanically connected to a lower end portion of said movable nozzle (52) and facing said upper surface (91) of said substrate (9) in the up-down direction, and
said local etching is performed while a liquid membrane (50b) is formed as said processing liquid fills a gap between a lower surface (631b) of said third electrode (63b) and said upper surface (91) of said substrate (9).

7. The substrate processing apparatus (1) according to any one of claims 2 to 6, further comprising:
a heater (25) that is provided in said substrate holder (21) to heat said substrate (9) from an underside,
wherein said heater (25) is capable of changing an amount of heat applied per unit area of a lower surface (92) of said substrate (9) according to a distance from a center of said substrate (9).

8. The substrate processing apparatus (1) according to any one of claims 2 to 7, wherein
in at least one of said overall etching or said local etching, a voltage applied between said first electrode (61) and said second electrode (62) or between said first electrode (61) and said third electrode (63) is repeatedly switched between a first voltage and a second voltage different from said first voltage in a predetermined switching cycle, to allow a potential on a side wall surface (942) to be repeatedly switched between a first potential and a second potential lower than said first potential, the side wall surface (942) forming a recessed portion (95) in a pattern (93) on said substrate (9),
said first potential is higher than or equal to 0V, and
said second potential is lower than or equal to 0V.

9. The substrate processing apparatus (1) according to claim 8, wherein
said switching cycle is more than or equal to 0.05 seconds.
